# EUROPEAN PATENT SPECIFICATION

(11) **EP 4 521 861 B1**
(45) Date of publication and mention of the grant of the patent: **09.09.2026**
(21) Application number: 22941772.0
(22) Date of filing: 12.05.2022
(51) Int. Cl.: G06F 1/16, G02F 1/1333, H04N 5/655, H05K 5/00, H05K 5/03, H05K 5/02

(54) **DISPLAY DEVICE**
ANZEIGEVORRICHTUNG
DISPOSITIF D'AFFICHAGE

(43) Date of publication of application: 12.03.2025
(73) Proprietor: LG Electronics Inc., Yeongdeungpo-gu Seoul 07336 (KR)
(72) Inventor: LEE, Baekki, Seoul 06772 (KR); CHOI, Kwangho, Seoul 06772 (KR); DO, Honghae, Seoul 06772 (KR); CHO, Jaewoo, Seoul 06772 (KR); JUNG, Jaechul, Seoul 06772 (KR)
(74) Representative: Schornack, Oliver
(86) International application number: PCT/KR2022/006812
(87) International publication number: WO 2023/219185

(56) References cited:
- CN-U- 213 582 941
- GB-A- 2 505 500
- KR-A- 20070 021 768
- KR-A- 20110 032 078
- KR-A- 20150 000 665
- KR-A- 20200 054 062
- US-A1- 2013 162 916
- US-A1- 2018 027 671
- US-A1- 2021 329 802
- US-A1- 2021 356 074

## Description

### [Technical Field]

The present disclosure relates to a display device.

### [Background Art]

As information society develops, the demand for display devices is also increasing in various forms. In response to this, various display devices such as Liquid Crystal Display Device (LCD), Plasma Display Panel (PDP), Electro luminescent Display (ELD), and Vacuum Fluorescent Display (VFD) have been researched and used in recent years.

Among these, a display device using organic light emitting diode (OLED) has the advantage of being able to be implemented in an ultra-thin form because it has superior brightness and viewing angle characteristics compared to a liquid crystal display device, and does not require a backlight unit.

Recently, much research has been conducted on a bracket for storing peripheral devices of display device.

For instance, GB 2 505 500A relates to a shelf assembly for mounting a flat screen television comprising a pair of spaced brackets supporting a shelf. A plurality of openings in the brackets are mountable to existing mounting holes on the rear of television. US 2013/0162916 is directed to a cantilevered shelf designed to be used with a flat screen television and providing a location for the placement of auxiliary small electronic equipment.

### [Disclosure]

### [Technical Problem]

An object of the present invention is to provide a display device having a more robust and stable mounting assembly.

### [Technical Solution]

This object is solved by the present invention as defined in the independent claim. Preferred embodiments are derivable from the dependent claims.

### [Advantageous Effects]

The effects of the display device according to the present invention will be described as follows.

According to at least one of the embodiments of the present invention, there is provided a display device including a bracket capable of accommodating a peripheral of the display device at the rear of the display device.

According to at least one of the embodiments of the present invention, there is provided a display device including a bracket capable of accommodating a peripheral of the display device and not being exposed at a front surface of the display device.

According to at least one of the embodiments of the present invention, there is provided a display device including a bracket capable of accommodating a peripheral of the display device at the rear of the display device and minimizing
According to at least one of the embodiments of the present invention, there is provided a display device capable of preventing loss of concentration when viewing the display device.

Further scope of applicability of the present disclosure will become apparent from the following detailed description. However, it should be understood that the detailed description and specific embodiments such as preferred embodiments of the present invention are given by way of illustration only.

### [Description of Drawings]

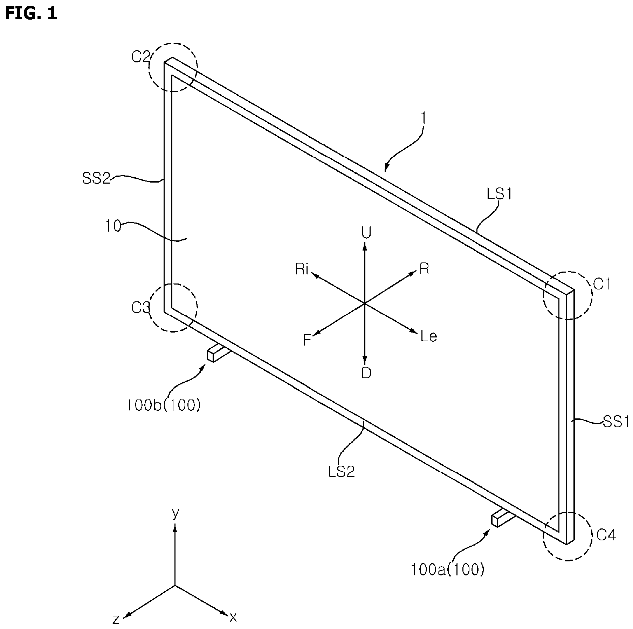

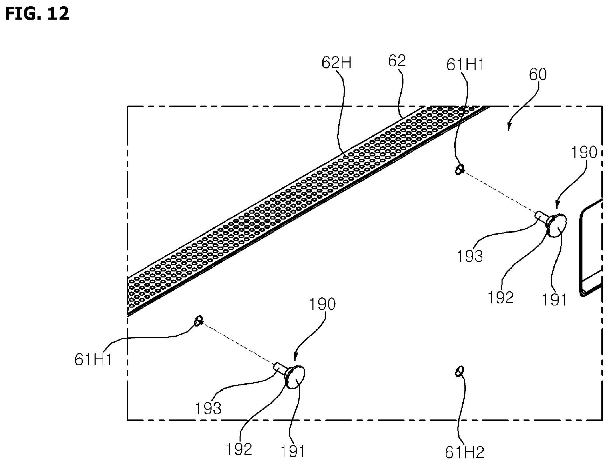

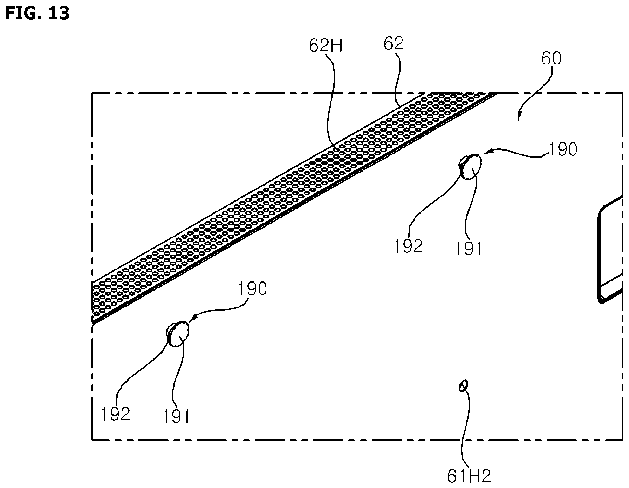

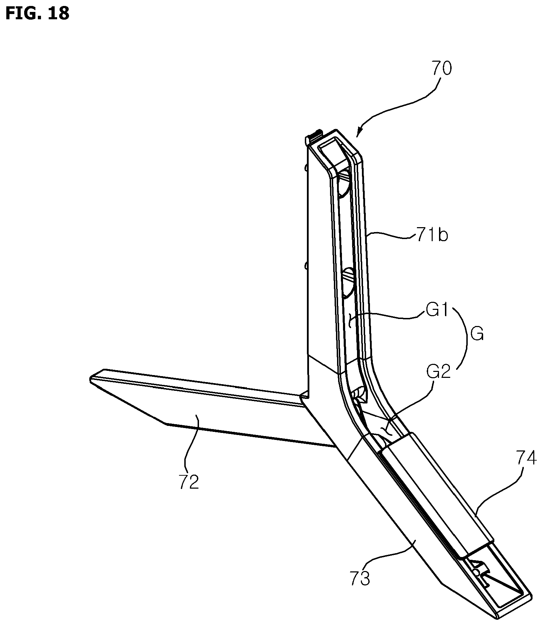

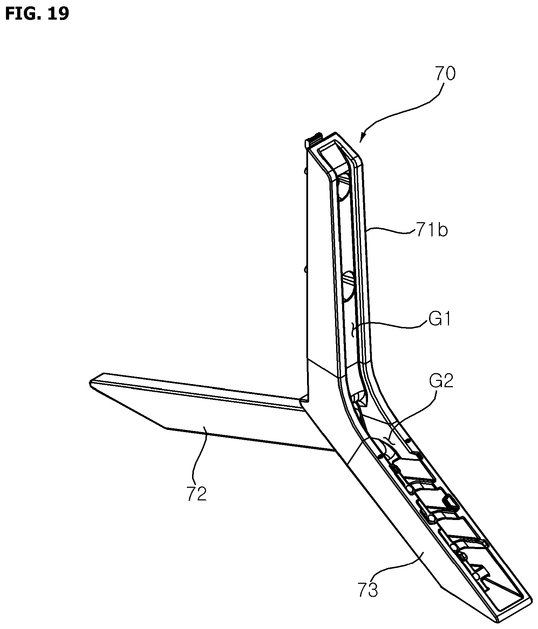

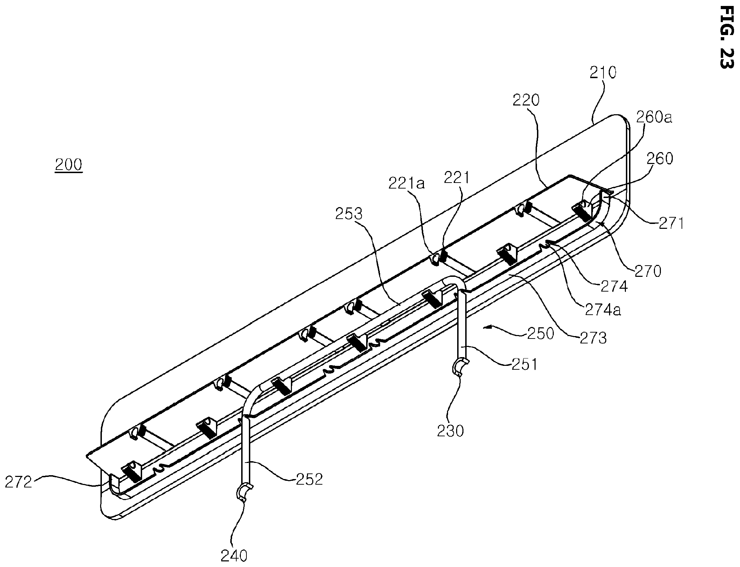

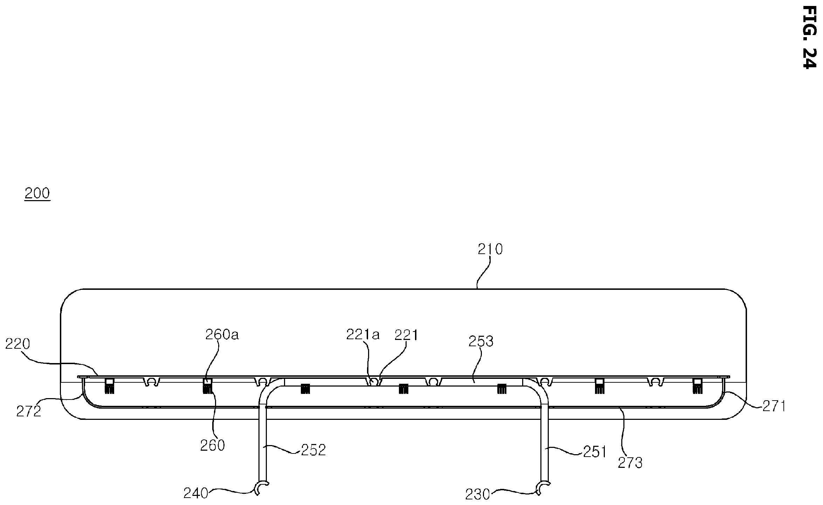

FIGS. 1 to 24 are diagrams illustrating examples of a display device according to embodiments of the present invention.

### [Mode for Invention]

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In general, suffixes such as "module" and "unit" may be used to refer to elements or components. Use of such suffixes herein is merely intended to facilitate description of the specification, and the suffixes do not have any special meaning or function.

In the present disclosure, a feature which is well known to one of ordinary skill in the relevant art has generally been omitted for the sake of brevity. The accompanying drawings are used to assist in easy understanding of various technical features and it should be understood that the embodiments presented herein are not limited by the accompanying drawings.

It will be understood that although the terms first, second, etc. may be used herein to describe various elements, these elements should not be limited by these terms. These terms are only used to distinguish one element from another.

It will be understood that when an element is referred to as being "connected with" another element, there may be intervening elements present. In contrast, it will be understood that when an element is referred to as being "directly connected with" another element, there are no intervening elements present.

A singular representation may include a plural representation unless context clearly indicates otherwise.

In the present application, it should be understood that the terms "comprises, includes," "has," etc. specify the presence of features, numbers, steps, operations, elements, components, or combinations thereof described in the specification, but do not preclude the presence or addition of one or more other features, numbers, steps, operations, elements, components, or combinations thereof.

Direction indications of up (U), down (D), left (Le), right (Ri), front (F), and rear (R) shown in the drawings are only for convenience of explanation, and the technical concept disclosed in this specification is not limited thereto.

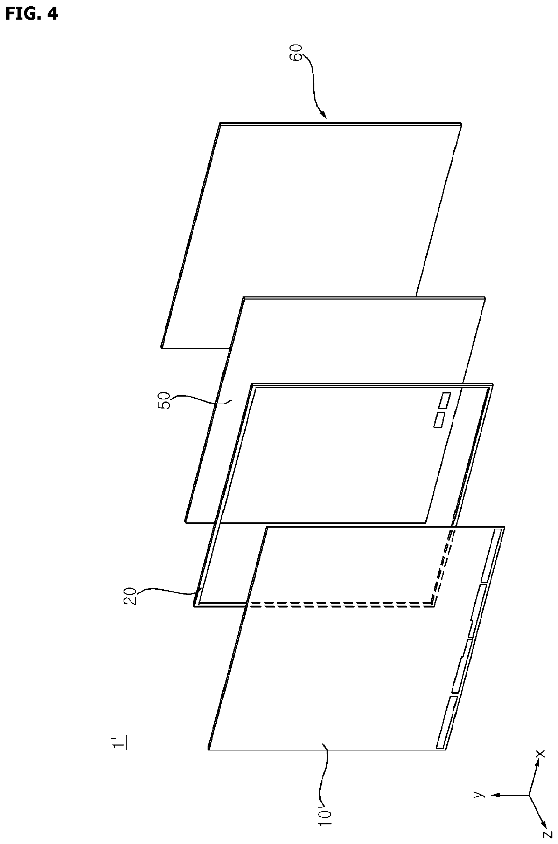

Hereinafter, the display panel of the present disclosure is described as an LCD panel (see FIGS. 1 to 3) or an OLED panel (see FIG. 4), but the type of display panel applicable to the present disclosure is not limited thereto.

Referring to FIG. 1, a display device 1 may include a display panel 10. The display panel 10 may display a screen.

The display device 1 may include a first long side LS1, a second long side LS2 opposite to the first long side LS1, a first short side SS1 adjacent to the first and second long sides LS1 and LS2, and a second short side SS2 opposite to the first short side SS1. Meanwhile, for convenience of description, it is illustrated that the length of the long side LS1, LS2 is larger than the length of the short side SS1, SS2, but it may also be possible that the lengths of the long side LS1, LS2 is substantially equal to the length of short side SS1, SS2.

The direction parallel to the long sides LS1 and LS2 of the display device 1 may be referred to as a left-right direction. The direction parallel to the short sides SS1 and SS2 of the display device 1 may be referred to as a vertical direction. The direction perpendicular to the long sides LS1 and LS2 and the short sides SS1 and SS2 of the display device 1 may be referred to as a forward/rearward direction.

The direction in which the display panel 10 displays images may be referred to as a forward direction (F, z), and the opposite direction may be referred to as a rearward direction R. A side of the first long side LS1 may be referred to as an upper side (U, y). A side of the second long side LS2 may be referred to as a lower side D. A side of the first short side SS1 may be referred to as a left side (Le, x). A side of the second short side SS2 may be referred to as a right side Ri.

The first long side LS1, the second long side LS2, the first short side SS1, and the second short side SS2 may be referred to as an edge of the display device 1. In addition, a point where the first long side LS1, the second long side LS2, the first short side SS1, and the second short side SS2 meet each other may be referred to as a corner.

For example, a point where the first short side SS1 and the first long side LS1 meet may be referred to as a first corner C1. A point where the first long side LS1 and the second short side SS2 meet may be referred to as a second corner C2. A point where the second short side SS2 and the second long side LS2 meet may be referred to as a third corner C3. A point where the second long side LS2 and the first short side SS1 meet may be referred to as a fourth corner C4.

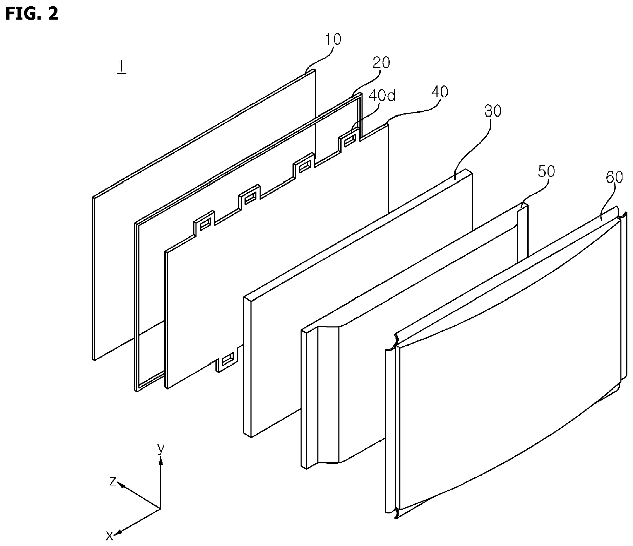

Referring to FIG. 2, a display device 1 includes a display panel 10, a guide panel 20, a backlight unit 30, 40, a frame 50, and a back cover 60.

The display panel 10 may form the front surface of the display device 1, and may display an image. The display panel 10 may display an image by having a plurality of pixels that output Red, Green or Blue (RGB) for each pixel in accordance with a timing. The display panel 10 may be divided into an active area where an image is displayed and a de-active area where an image is not displayed. The display panel 10 may include a front substrate and a rear substrate that are opposite to each other with a liquid crystal layer interposed therebetween. The display panel 10 may be referred to as an LCD panel.

The front substrate may include a plurality of pixels consisting of red, green, and blue subpixels. The front substrate may output a light corresponding to the color of red, green, or blue depending on a control signal.

The rear substrate may include switching elements. The rear substrate may switch a pixel electrode. For example, the pixel electrode may change the molecular arrangement of a liquid crystal layer according to an externally input control signal. The liquid crystal layer may include liquid crystal molecules. The arrangement of liquid crystal molecules may change in response to a voltage difference generated between the pixel electrode and a common electrode. The liquid crystal layer may transmit or block a light provided from the backlight unit 30, 40 to the front substrate.

The guide panel 20 may surround the circumference of the display panel 10, and cover the side surface of the display panel 10. The guide panel 20 may be coupled to the display panel 10 or may support the display panel 10. The guide panel 20 may be referred to as a side frame or a middle cabinet.

The backlight unit 30, 40 may be located in a rear of the display panel 10. The backlight unit 30, 40 may include light sources. The backlight unit 30, 40 may be coupled to the frame 50 in front of the frame 50. The backlight unit 30, 40 may be driven by a full driving method or a partial driving method such as local dimming, and impulsive driving. The backlight unit 30, 40 may include an optical sheet 40 and an optical layer 30.

The optical sheet 40 may evenly transmit light from the light source to the display panel 10. The optical sheet 40 may be composed of a plurality of layers. For example, the optical sheet 40 may include a prism sheet or a diffusion sheet. Meanwhile, a coupling portion 40d of the optical sheet 40 may be coupled to the frame 50 and/or the back cover 60.

The frame 50 may be located in a rear of the backlight unit 30, 40, and may support the components of the display device 1. The edge of the frame 50 may be fixed to the guide panel 20. For example, components such as backlight unit 30, 40 and a printed circuit board (PCB) on which a plurality of electronic devices are located may be coupled to the frame 50. For example, the frame 50 may include a metal material. The frame 50 may be referred to as a main frame, a module cover, or a cover bottom.

The back cover 60 may be located at the rear of the frame 50. The back cover 60 may cover the rear of the frame 50. For example, the back cover 60 may cover the rear front surface of the frame 50. In this case, the vertical height of the back cover 60 may be greater than or equal to the vertical height of the frame 50. For example, the back cover 60 may cover at least a portion of the rear of the frame 50. In this case, the vertical height of the back cover 60 may be less than the vertical height of the frame 50. The back cover 60 may be coupled to the frame 50. The back cover 60 may be coupled to the rear of the frame 50. For example, the back cover 60 may include a metal material.

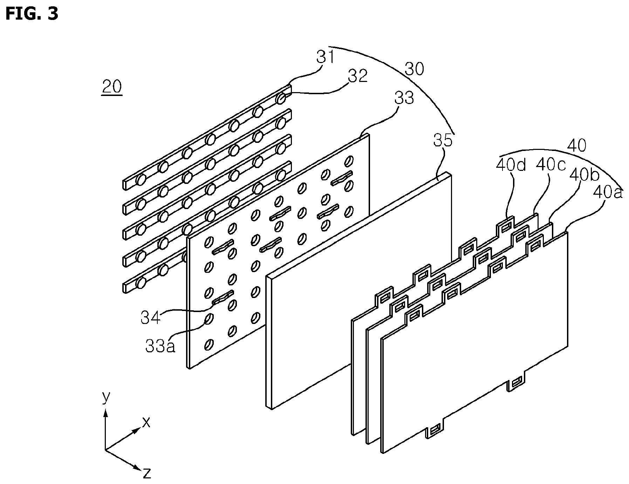

Referring to FIG. 3, the optical layer 30 may include a substrate 31, at least one optical assembly 32, a reflective sheet 33, and a diffusion plate 35. The optical sheet 40 may be located in front of the optical layer 30.

The substrate 31 may extend in the left-right direction, and may be provided in the form of a plurality of straps spaced apart from each other in the vertical direction. At least one optical assembly 32 may be mounted on the substrate 31. An electrode pattern may be formed on the substrate 31 to connect an adapter and the optical assembly 32. For example, the electrode pattern may be a carbon nanotube electrode pattern. The substrate 31 may be composed of at least one of polyethylene terephthalate (PET), glass, polycarbonate (PC), and silicon. The substrate 31 may be a printed circuit board (PCB) on which at least one optical assembly 32 is mounted.

The optical assembly 32 may be a light emitting diode (LED) chip or a light emitting diode package including at least one light emitting diode chip. The optical assembly 32 may be composed of a colored LED or a white LED that emits at least one color among colors such as red, green, and blue. The colored LED may include at least one of red LED, green LED, and blue LED.

The reflective sheet 33 may be located in front of the substrate 31. At least one hole 33a may be formed to penetrate the reflective sheet 33, and the optical assembly 32 may be located in the hole 33a. The reflective sheet 33 may reflect a light provided from the optical assembly 32 or reflected from the diffusion plate 35 forward. For example, the reflective sheet 33 may include a metal having a high reflectivity, such as at least one of aluminum (Al), silver (Ag), gold (Au), and titanium dioxide (TiO2) and/or metal oxide.

In addition, an air gap may be formed between the reflective sheet 33 and the diffusion plate 35. The air gap may serve as a buffer, and the light provided from the optical assembly 32 may be spread widely by the air gap. The supporter 34 may be located between the reflective sheet 33 and the diffusion plate 35, and may form the air gap.

The diffusion plate 35 may be located in front of the reflective sheet 33. The diffusion plate 35 may be located between the reflective sheet 33 and the optical sheet 40.

The optical sheet 40 may include at least one sheet. For example, the optical sheet 40 may include one or more prism sheets and/or one or more diffusion sheets. A plurality of sheets of the optical sheet 40 may be adhered or in close contact with each other.

Specifically, the optical sheet 40 may be composed of a plurality of sheets having different functions. For example, the optical sheet 40 may include a first optical sheet 40a, a second optical sheet 40b, and a third optical sheet 40c. For example, the first optical sheet 40a may be a diffusion sheet, and the second optical sheet 40b and the third optical sheet 40c may be a prism sheet. The diffusion sheet may prevent the light emitting from the diffusion plate 35 from being partially concentrated, thereby making the distribution of light more uniform. The prism sheet may condense the light emitting from the diffusion plate 35 and provide it to the display panel 10. Meanwhile, the number and/or location of the diffusion sheet and the prism sheet may be changed.

Referring to FIG. 4, a display device 1' may include a display panel 10', a guide panel 20, a frame 50, and a back cover 60.

The display panel 10' may form the front surface of the display device 1' and may display an image. The display panel 10' may divide an image into a plurality of pixels and output an image in accordance with color, brightness, and saturation for each pixel. The display panel 10' may be divided into an active area where image is displayed and a de-active area where image is not displayed. The display panel 10' may generate light corresponding to the colors of red, green, or blue depending on a control signal. The display panel 10' may be referred to as an OLED panel.

The guide panel 20' may surround the circumference of the display panel 10', and cover the side surface of the display panel 10'. The guide panel 20' may be coupled to the display panel 10' or may support the display panel 10'. The guide panel 20' may be referred to as a side frame or a middle cabinet.

The frame 50 may be located in a rear of the display panel 10', and the display panel 10' may be coupled thereto. The edge of the frame 50 may be fixed to the guide panel 20. Electronic components may be mounted in the frame 50. For example, the frame 50 may include a metal material. The frame 50 may be referred to as a main frame, a module cover, or a cover bottom.

The back cover 60 may be located at the rear of the frame 50. The back cover 60 may cover the rear of the frame 50. For example, the back cover 60 may cover the rear front surface of the frame 50. In this case, the vertical height of the back cover 60 may be greater than or equal to the vertical height of the frame 50. For example, the back cover 60 may cover at least a portion of the rear of the frame 50. In this case, the vertical height of the back cover 60 may be less than the vertical height of the frame 50. The back cover 60 may be coupled to the frame 50. The back cover 60 may be coupled to the rear of the frame 50. For example, the back cover 60 may include a metal material.

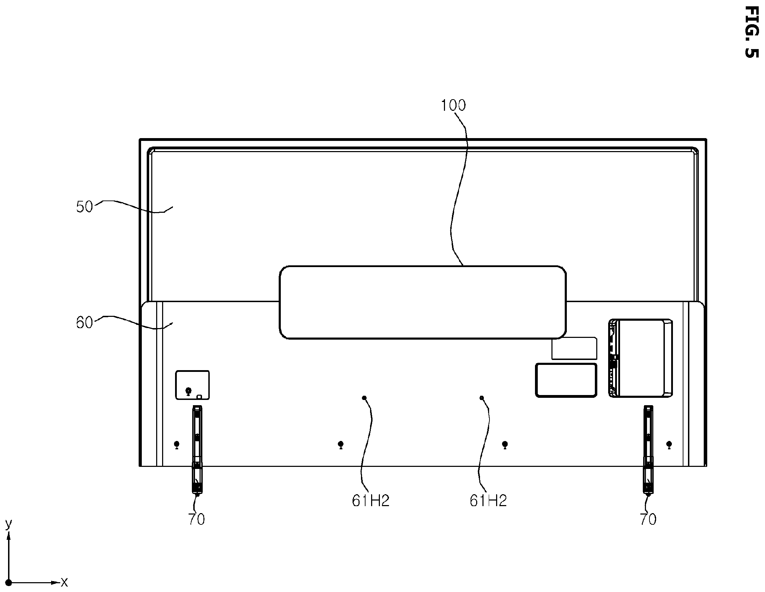

Referring to FIG. 5, the bracket 100 may be arranged at the rear of a display device 1, 1'. The cross-sectional area of the bracket 100 may be smaller than the cross-sectional area of the display panel 10. The bracket 100 may be located between the upper side and the lower side of the display device 1, 1'. The bracket 100 may be spaced downward from the upper side of the display device 1, 1' and may be spaced upward from the lower side of the display device 1, 1'. The bracket 100 may be located between the left side and the right side of the display device 1, 1'.

The bracket 100 may be spaced rightward from the left side of the display device 1, 1' and may be spaced leftward from the right side of the display device 1, 1'. The bracket 100 may not be exposed to the front of the display device 1, 1'. The bracket 100 may be located at the center of the rear of the display device 1, 1'. The distance between the upper end of the bracket 100 and the upper side of the display device 1, 1' may be the same as the distance between the lower end of the bracket 100 and the lower side of the display device 1, 1'.

The distance between the left distal end of the bracket 100 and the left side of the display device 1, 1' may be the same as the distance between the right distal end of the bracket 100 and the right side of the display device 1, 1'. In this case, not only the bracket 100, but also peripheral devices related to the display device 1, 1' accommodated in the bracket 100 may not be exposed at the front of the display device 1, 1'. However, the present invention is not limited thereto, and the bracket 100 may be located at a position that is not exposed to the front of the display device 1, 1'.

In addition, the bracket 100 may be located at a position where peripheral devices accommodated in the bracket 100 are not exposed at the front of the display device 1, 1'. For example, the distance between the upper end of the bracket 100 and the upper side of the display device 1, 1' may be greater than the distance between the lower end of the bracket 100 and the lower side of the display device 1, 1'.

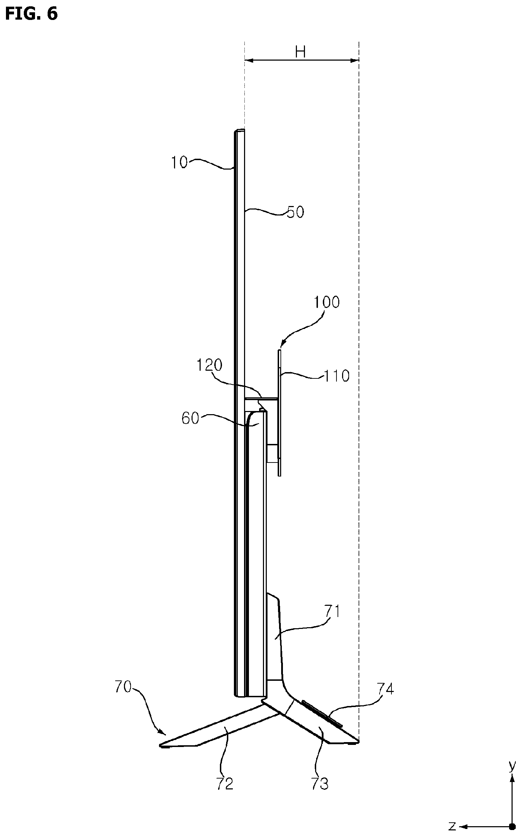

Referring to FIGS. 5 and 6, the bracket 100 may be located at the rear of the module cover 50. The bracket 100 is coupled to the rear of the back cover 60. The plate 110 may be formed in a tetragonal shape. For example, the plate 110 may be formed in a rectangular shape. For example, the plate 110 may have a rectangular shape in which the side facing the long side of the display device 1, 1' is formed as a long side, and the side facing the short side of the display device 1, 1' is formed as a short side.

However, it is not limited thereto, and the plate 110 may have a rectangular shape in which the side facing the long side of the display device 1, 1' is formed as a short side, and the side facing the short side of the display device 1, 1' is formed as a long side. In addition, the plate 110 may have a square shape.

The plate 110 may be provided as a flat plate including a flat surface. The plate 110 is arranged parallel to the back cover 60. The plate 110 may be arranged parallel to the module cover 50. The plate 110 may overlap with the back cover 60 in the forward/rearward direction. For example, a portion of the plate 110 may overlap with the module cover 50 in the forward/rearward direction, and the remainder of the plate 110 may overlap with the back cover 60 in the forward/rearward direction. Alternatively, the entire plate 110 may overlap with the back cover 60 in the forward/rearward direction.

The plate 110 may be spaced in a rearward direction from the back cover 60. The plate 110 may be spaced in a rearward direction from the module cover 50. The distance between the plate 110 and the module cover 50 may be formed to be greater than the distance between the plate 110 and the back cover 60.

Referring to FIGS. 6, 7, and 8, a shelf 120 may be located between the plate 110 and the module cover 50. The shelf 120 may be located between the plate 110 and the back cover 60. One end of the shelf 120 may be coupled to the plate 110, and the other end may be spaced apart from the module cover 50 by a certain distance. One end of the shelf 120 may be fixed to the plate 110, and the other end may be in contact with the module cover 50. The shelf 120 may extend from the plate 110 toward the module cover 50. The shelf 120 may extend in a direction intersecting both the plate 110 and the module cover 50. The shelf 120 may extend in a direction intersecting both the plate 110 and the back cover 60.

The shelf 120 may be arranged on the back cover 60. The shelf 120 may overlap with the back cover 60 in an upward/downward direction. Peripheral devices of the display device 1, 1' may be received in the shelf 120. The peripheral devices of the display device 1, 1' may be placed on the shelf 120. The upper space of the shelf 120 may be a space where peripheral devices of the display device 1, 1' are accommodated, and the lower space of the shelf 120 may be a space where a connecting member such as a wire and a cable connected to the peripheral devices of the display device 1, 1' is located. According to an embodiment of the present disclosure, peripheral devices may be received at the rear of the display device 1, 1' while minimizing the distance between a wall and the display device 1, 1'.

The shelf 120 may include a horizontal portion 121. The horizontal portion 121 may extend in the long side direction of the plate 110. The longitudinal direction of the horizontal portion 121 may be parallel to the long side LS1, LS2 of the display device 1, 1'. The horizontal portion 121 may have a length shorter than the long side of the plate 110. The horizontal portion 121 may include a plurality of horizontal portions 121. The plurality of horizontal portions 121 may be spaced apart in the forward/rearward direction.

The plurality of horizontal portions 121 may include a first horizontal portion 121a fixed to the plate 110 and a second horizontal portion 121b that is spaced apart from the first horizontal portion 121a in a direction toward the module cover 50 and faces the module cover 50. The plurality of horizontal portions 121 may further include a third horizontal portion 121c located between the first horizontal portion 121a and the second horizontal portion 121b. There may be provided a plurality of third horizontal portions 121c. The distance between the plurality of horizontal portions 121 may be formed to be the same. Alternatively, the distance between the plurality of horizontal portions 121 may be formed differently.

The shelf 120 may include a vertical portion 122. The vertical portion 122 may extend in a direction perpendicular to the extension direction of the horizontal portion 121. The vertical portion 122 may extend from the plate 110 toward the display device 1, 1'. The vertical portion 122 may extend from the plate 110 toward the module cover 50. The vertical portion 122 may extend from the plate 110 toward the back cover 60. The length of the vertical portion 122 may be shorter than the length of the horizontal portion 121. The length of the vertical portion 122 may be equal to or shorter than the distance between the plate 110 and the display device 1, 1'.

The vertical portion 122 may be coupled to the horizontal portion 121. The vertical portion 122 may be coupled to a plurality of horizontal portions 121. The vertical portion 122 may connect the plurality of horizontal portions 121. The vertical portion 122 may include a plurality of vertical portions 122. The plurality of vertical portions 122 may be spaced apart in the left-right direction. The plurality of vertical portions 122 may be spaced apart along the length direction of the horizontal portion 121. The plurality of vertical portions 122 may include a first vertical portion 122a connecting left distal ends of the plurality of horizontal portions 121 and a second vertical portion 122b connecting right distal ends of the plurality of horizontal portions 121. The plurality of vertical portions 122 may further include a third vertical portion 122c located between the first vertical portion 122a and the second vertical portion 122b. The third vertical portion 122c may include a plurality of third vertical portions 122c. The plurality of third vertical portions 122c may be spaced apart in the left-right direction. The plurality of third vertical portions 122c may be spaced apart at equal intervals. The plurality of vertical portions 122 may be spaced apart at equal intervals.

The shelf 120 may include a hole 123. The hole 123 may be formed between the horizontal portion 121 and the vertical portion 122. The hole 123 may include a plurality of holes 123 formed between the plurality of horizontal portions 121 and the plurality of vertical portions 122. A peripheral device of the display device 1, 1' may be mounted in the horizontal portion 121 and the vertical portion 122, and a connecting member such as a wire or cable connected to the peripheral device may pass through the hole 123.

The bracket 100 may include a coupling portion 130, 140. The coupling portion 130, 140 may fix the bracket 100 to the display device 1, 1'. The coupling portion 130, 140 may fix the bracket 100 to the back cover 60. The coupling portion 130, 140 may be located in the plate 110.

The coupling portion 130, 140 may be located in the lower area of the plate 110. The coupling portion 130, 140 may be located at a position where the plate 110 and the back cover 60 face each other, when the bracket 100 is mounted on the display device 1, 1'. The coupling portion 130, 140 may be located at a position lower than the shelf 120. The coupling portion 130, 140 may be adjacent to the lower end of the plate 110.

The coupling portion 130, 140 may protrude from the inner side of the plate 110. The coupling portion 130, 140 may face the rear surface of the back cover 60. The coupling portion 130, 140 may be coupled to a fastening member 190 coupled to the back cover 60 described below. The coupling portion 130, 140 may be spanned over the fastening member 190. The coupling portion 130, 140 may have a space, formed therein, that may accommodate a head 191 of the fastening member 190, and may have an open lower surface.

The coupling portion 130, 140 may include a first coupling portion 130 and a second coupling portion 140. The first coupling portion 130 may be connected to a first fastening member 190a described later, and the second coupling portion 140 may be connected to a second fastening member 190b described later. The first coupling portion 130 and the second coupling portion 140 may be spaced apart in the left-right direction. The first coupling portion 130 and the second coupling portion 140 may have the same shape. The first coupling portion 130 and the second coupling portion 140 may be symmetrical in a left-right direction about a center line extending in an up-down direction through the center of the plate 110.

The first coupling portion 130 may include a first surface 131 facing the back cover 60, a second surface 132 that connects the first surface 131 and the plate 110 and faces downward, and a third surface 133 that connects the first surface 131 and the plate 110 and is located on the opposite side of the second surface 132.

The first coupling portion 130 may include a first slot 134. The head 191 of the fastening member 190 may be inserted into the first slot 134. The first slot 134 may be formed by being recessed in a direction from the second surface 132 of the first coupling portion 130 toward the third surface 133 of the first coupling portion 130. The first slot 134 may be a groove recessed from the second surface 132 of the first coupling portion 130 toward the third surface 133. The first slot 134 may be opened to the first surface 131 of the first coupling portion 130. The first slot 134 may be opened to the second surface 132 of the first coupling portion 130. The second surface 132 may be an opening that is opened downward.

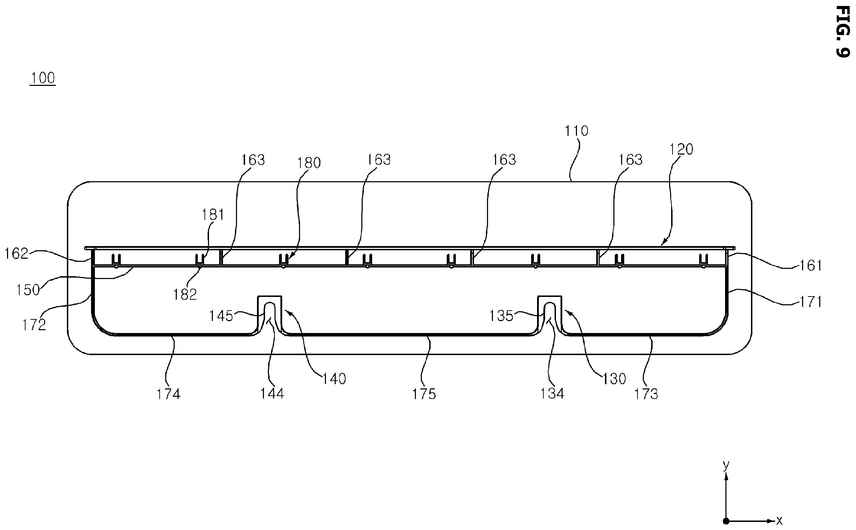

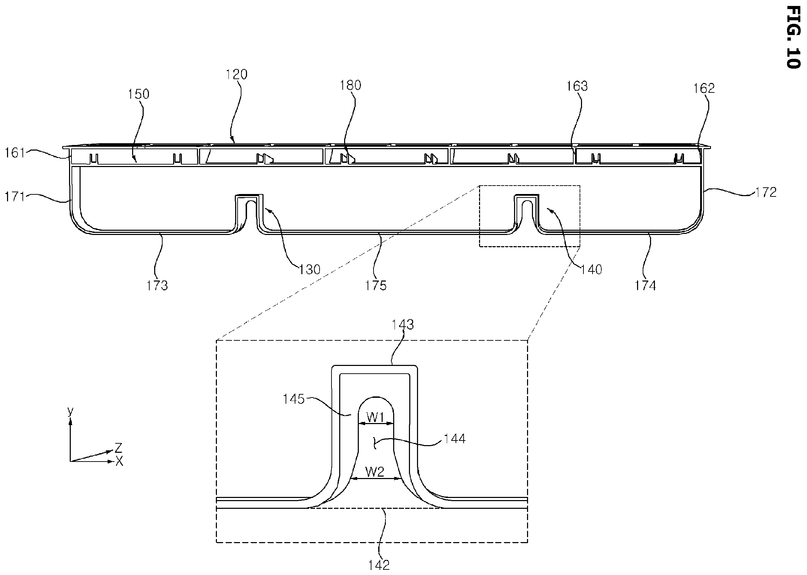

Referring to FIGS. 9 and 10, the width of the first slot 134 in the left-right direction may increase from the third surface 133 of the first coupling portion 130 toward the second surface 132 of the first coupling portion 130. The width W1 of the portion where the first slot 134 is adjacent to the third surface 133 of the first coupling portion 130 may be smaller than the width W2 of a portion where the first slot 132 is adjacent to the second surface 132 of the first coupling portion 130. Through this, when the bracket 100 is coupled to the fastening member 190, the head 191 of the fastening member 190 may be guided to be inserted into the first slot 134.

A first support portion 135 may form a boundary of the first slot 134. The first support portion 135 may protrude along the boundary of the first slot 134. The first support portion 135 may protrude inwardly from at least a portion of the inner surface of the first slot 134. The first support portion 135 may form the same plane as the first surface 131 of the first coupling portion 130. The width of the first support portion 135 in the left-right direction may be smaller than the width of the first slot 134 in the left-right direction. The width of the first support portion 135 may be smaller than the diameter of the head 191 of the fastening member 190. The first support portion 135 may overlap with the head 191 of the fastening member 190 in the forward/rearward direction.

The width of the first support portion 135 in the left-right direction may increase in the direction from the third surface 133 of the first coupling portion 130 toward the second surface 132. The first support portion 135 may have a first width W1 at a portion adjacent to the third surface 133 of the first coupling portion 130, and may have a second width W2 at a portion adjacent to the second surface 132 of the first coupling portion 130. The first width W1 may be smaller than the second width W2. The first width W1 may be equal to the diameter of a neck 192 of the fastening member 190. The second width W2 may be larger than the diameter of the neck 192 of the fastening member 190. The first width W1 and the second width W2 may be smaller than the diameter of the head 191 of the fastening member 190.

The second coupling portion 140 may include a first surface 141 facing the back cover 60, a second surface 142 that connects the first surface 141 and the plate 110 and faces downward, and a third surface 143 that connects the first surface 141 and the plate 110 and is located on the opposite side of the second surface 142. The second coupling portion 140 may have a second slot 144 into which the head 191 of the fastening member 190 is inserted. The second slot 144 may be formed by being recessed in a direction from the third surface 143 of the second coupling portion 140 toward the second surface 142. The second slot 144 may be opened to the first surface 141 of the second coupling portion 140. The second slot 144 may be opened to the second surface 142 of the second coupling portion 140. It may be opened to the second surface 142.

A second support portion 145 may form a boundary of the second slot 144. The second support portion 145 may protrude along the boundary of the second slot 144. The second support portion 145 may protrude inwardly from at least a portion of the inner surface of the second slot 144. The second support portion 145 may form the same plane as the first surface 141 of the second coupling portion 140. The width of the second support portion 145 in the left-right direction may be smaller than the width of the second slot 144 in the left-right direction. The width of the second support portion 145 may be smaller than the diameter of the head 191 of the fastening member 190. The second support portion 145 may overlap with the head 191 of the fastening member 190 in the forward/rearward direction.

Referring to FIGS. 9 and 10, the width of the second slot 144 in the left-right direction may increase in the direction from the third surface 143 of the second coupling portion 140 toward the second surface 142 of the second coupling portion 140. The width W1 of a portion where the second slot 144 is adjacent to the third surface 143 of the second coupling portion 140 may be smaller than the width W2 of a portion where the second slot 144 is adjacent to the second surface 142 of the second coupling portion 140. Through this, when the bracket 100 is coupled to the fastening member 190, the head 191 of the fastening member 190 may be guided to be inserted into the second slot 144.

The second support portion 145 may form a boundary of the second slot 144. The second support portion 145 may protrude along the boundary of the second slot 144. The second support portion 145 may protrude inwardly from at least a portion of the inner surface of the second slot 144. The second support portion 145 may form the same plane as the first surface 141 of the second coupling portion 140. The width of the second support portion 145 in the left-right direction may be smaller than the width of the second slot 144 in the left-right direction. The width of the second support portion 145 may be smaller than the diameter of the head 191 of the fastening member 190. The second support portion 145 may overlap with the head 191 of the fastening member 190 in the forward/rearward direction.

The width of the second support portion 145 in the left-right direction may increase in the direction from the third surface 143 of the second coupling portion 140 toward the second surface 142. The second support portion 145 may have a first width W1 at a portion adjacent to the third surface 143 of the second coupling portion 140, and may have a second width W2 at a portion adjacent to the second surface 142 of the second coupling portion 140. The first width W1 may be smaller than the second width W2. The first width W1 may be equal to the diameter of the neck 192 of the fastening member 190. The second width W2 may be larger than the diameter of the neck 192 of the fastening member 190. The first width W1 and the second width W2 may be smaller than the diameter of the head 191 of the fastening member 190.

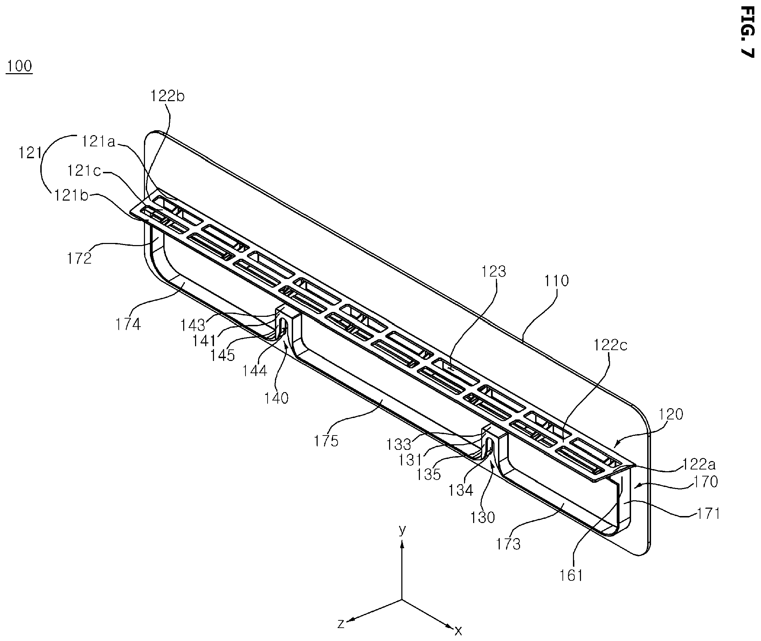

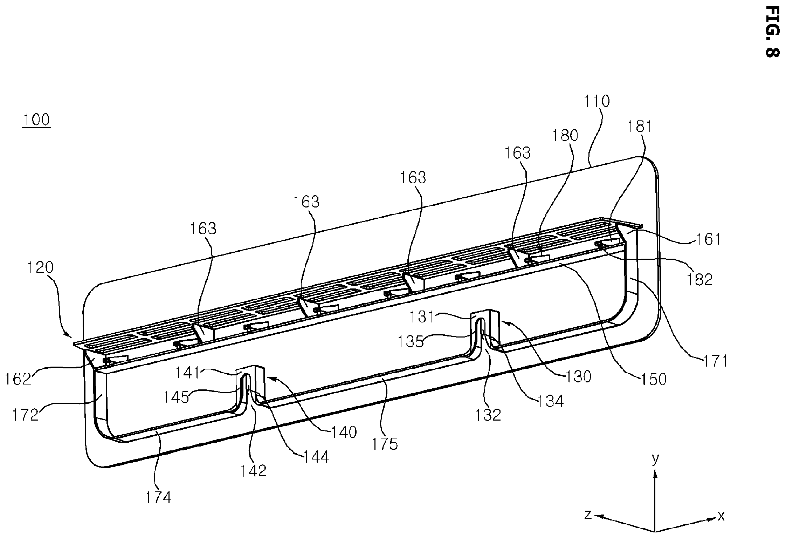

Referring again to FIGS. 7 and 8, the bracket 100 may include a support frame 150. The support frame 150 may be arranged on the plate 110. The support frame 150 may extend in a direction intersecting with the plate 110. The support frame 150 may extend in a direction intersecting with the back cover 60 or the module cover 50. The support frame 150 may protrude from the plate 110 toward the display device 1, 1'. The support frame 150 may have a plane parallel to the shelf 120. The support frame 150 may be provided as a flat plate. The support frame 150 may be located below the shelf 120 on the plate 110. The support frame 150 may be located between the shelf 120 and the coupling portion 130, 140. The support frame 150 may be located closer to the shelf 120 than the coupling portion 130, 140. The width of the support frame 150 in the forward/rearward direction may be smaller than the width of the shelf 120 in the forward/rearward direction. The width of the support frame 150 in the forward/rearward direction may be smaller than the length of the vertical portion 122 of the shelf 120.

A rib 160 may be located between the shelf 120 and the support frame 150. The lower end of the rib 160 may be fixed to the support frame 150, and the upper end of the rib 160 may be fixed to the bottom surface of the shelf 120. The rib 160 may support the bottom surface of the shelf 120. The length of the lower end of the rib 160 in the forward/rearward direction may correspond to the width of the support frame 150, and the length of the upper end of the rib 160 in the forward/rearward direction may correspond to the length of the vertical portion 122 of the shelf 120. For example, the rib 160 may have a trapezoidal shape. The rib 160 may support the vertical portion 122 of the shelf 120. The rib 160 may reinforce the rigidity of the shelf 120.

The rib 160 may include a plurality of ribs 160. The plurality of ribs 160 may be spaced apart from each other in the left-right direction. The rib 160 may include a first rib 161 coupled with the first vertical portion 122a and a second rib 162 coupled with the second vertical portion 122a. The rib 160 may further include a third rib 163 located between the first rib 161 and the second rib 162. The third rib 163 may include a plurality of third ribs 163. The third rib 163 may support the third vertical portion 122c. The third rib 163 may support some of the plurality of third vertical portions 122c. Alternatively, the third rib 163 may support all of the plurality of vertical sections 122c.

The bracket 100 may include a connecting frame 170. The connecting frame 170 may connect the first rib 161, the second rib 162, a second coupling portion 130, and a fourth coupling portion 140. The connecting frame 170, the first rib 161, the second rib 162, the second coupling portion 130, and the fourth coupling portion 140 may be formed as one body. The connecting frame 170 may include a first part 171 that is connected to the first rib 161 and extends in the up-down direction, and a second part 172 that is connected to the second rib 162 and extends in the up-down direction. The first part 171 and the second part 172 may be symmetrical in the left-right direction with respect to a center line extending vertically through the center of the plate 110.

The connecting frame 170 may include a third part 173 that extends in the left-right direction from the first part 171 and is connected to the first coupling portion 130, a fourth part 174 that extends in the left-right direction from the second part 171 and is connected to the second coupling portion 140, and a fifth part 175 that extends in the left-right direction and connects the first coupling portion 130 and the second coupling portion 140. The third part 173 may be connected to the second surface 132 of the first coupling portion 130. The fourth part 174 may be connected to the second surface 142 of the second coupling portion 140. The fifth part 175 may be connected to the second surface 132 of the first coupling portion 130 and may be connected to the second surface 142 of the second coupling portion 140. The connecting portion of the first part 171 and the third part 173 may be formed in a round shape. The connecting portion of the second part 172 and the fourth part 174 may be formed in a round shape. Both ends of the support frame 150 may be coupled between the first part 171 and the second part 172. Through the connecting frame 170, the rigidity of the shelf 120 may be additionally secured.

The bracket 100 may include a fixing portion 180. The fixing portion 180 may be arranged on the plate 110. The fixing portion 180 may include a plurality of fixing portions 180. The plurality of fixing portions 180 may be spaced apart from each other in the left-right direction. The fixing portion 180 may be located between the rib 160 and the rib 160. The fixing portion 180 may be located between the neighboring third ribs 163 among the plurality of third ribs 163.

The fixing portion 180 includes a fixing body 181 protruding in a forward direction from the plate 110, and a protrusion 182 protruding downward from a distal end of the fixing body 181. The fixing body 181 may include a first portion coupled to the support frame 150, and a second portion that extends in a forward direction from the first portion and does not overlap with the support frame 150 in the up-down direction. The first portion of the fixing body 181 may be supported by the support frame 150. The second portion of the fixing body 181 may protrude forward than the support frame 150. The second portion of the fixing body 181 may overlap with the back cover 60 in the up-down direction. The second portion of the fixing body 181 may be located above the back cover 60.

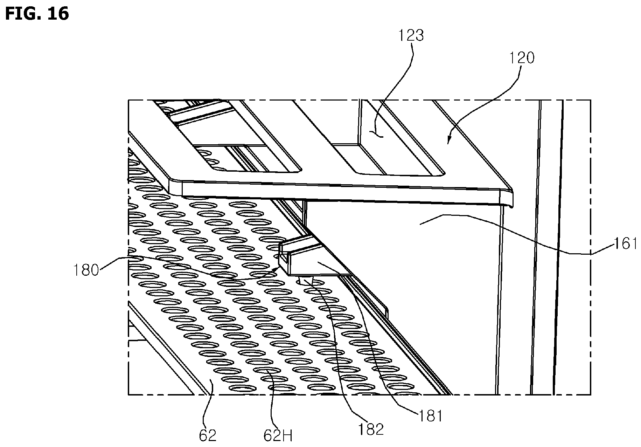

The width of the fixing body 181 may become smaller as it goes forward from the plate 110. The fixing body 181 may have a triangular or trapezoidal shape. The protrusion 182 protrudes downward from a distal end of the fixing body 181. The protrusion 182 may protrude downward from the second portion of the fixing body 181. The protrusion 182 may be located forward than the support frame 150. The protrusion 182 may overlap with the support frame in the forward/rearward direction. The protrusion 182 is inserted into a hole 62H formed on an upper surface 62 of the back cover 60 (see FIG. 16). The protrusion 182 is inserted into at least one hole 62H among a plurality of holes 62H formed on the upper surface 62 of the back cover 60. The fixing portion 180 may fix the bracket 100 with respect to the back cover 60.

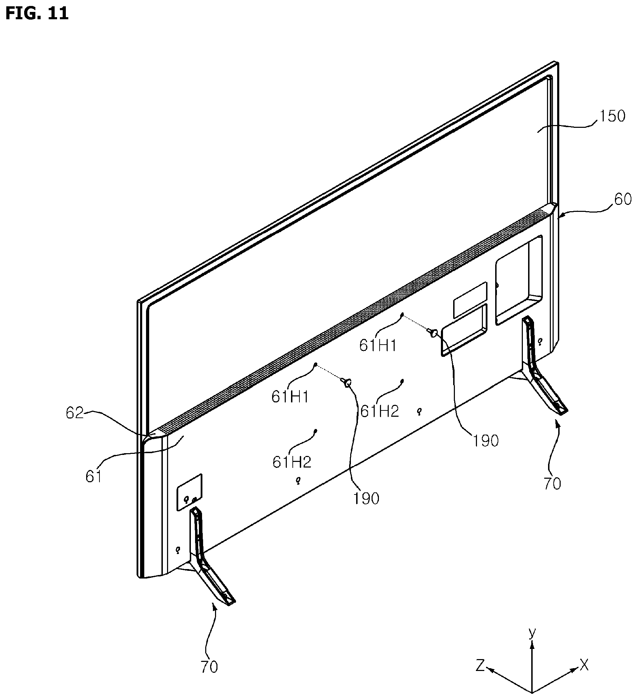

Referring to FIG. 11, a mounting hole 61H1, 61H2 is formed on the rear surface 61 of the back cover 60. The mounting hole 61H1, 61H2 may be formed by penetrating the back cover 60. The mounting hole 61H1, 61H2 may include a pair of first mounting holes 61H1 spaced apart from each other in the left-right direction. The mounting hole 61H1, 61H2 may include a pair of second mounting holes 61H2 spaced apart from each other in the left-right direction. The first mounting hole 61H1 may be formed above the second mounting hole 61H2. The first mounting hole 61H1 and the second mounting hole 61H2 may be aligned in the up-down direction. Meanwhile, the mounting hole 61H1, 61H2 may be referred to as a Video Electronics Standards Association Hole (VESA hole).

Referring to FIGS. 11 to 13, a fastening member 190 is inserted into the first mounting hole 61H1. The fastening member 190 may include a head 191, a neck 192, and a fin 193. The head 191 may be formed in a circular plate or disk shape. The fin 193 may be coupled to the center of the head 191. The fin 193 may have a diameter smaller than the diameter of the head 191. The fin 193 may be inserted into the first mounting hole 61H1 of the back cover 60. The neck 192 may be located between the head 191 and the fin 193. The neck 192 may have a diameter smaller than the diameter of the head 191, and have a diameter larger than the diameter of the fin 193. The neck 192 may separate the head 191 from the rear surface 61 of the back cover 61.

The fastening member 190 may include a plurality of fastening members 190. The fastening member 190 may be provided in a number corresponding to the first mounting hole 61H1. The fastening member 190 may include a first fastening member 190a and a second fastening member 190b that are coupled to each of a pair of first mounting holes 61H1.

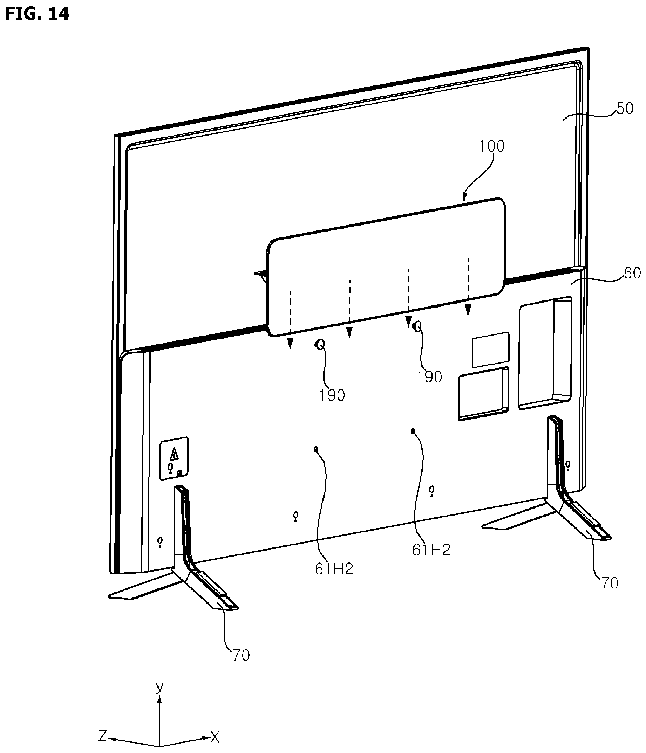

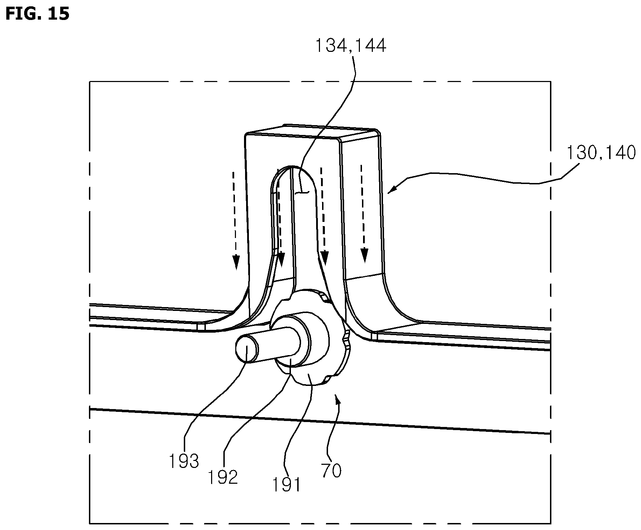

Referring to FIGS. 14 and 15, the bracket 100 is detachably coupled to the display device 1, 1'. The bracket 100 is detachably coupled to the back cover 60. The bracket 100 may be slidably coupled to the back cover 60. The bracket 100 may be moved from top to bottom to be spanned over the back cover 60. The bracket 100 may be moved upward and may be separated from the back cover 60. That is, the bracket 100 may be moved in the up-down direction and may be mounted on or detached from the back cover 60.

When the bracket 100 is coupled to the back cover 60, the coupling portion 130, 140 of the bracket 100 may be spanned over the fastening members 190 inserted into the back cover 60. For example, the bracket 100 may be spanned over the fastening member 190 inserted into the first mounting hole 61H1. For example, the bracket 100 may be spanned over the fastening member 190 inserted into the second mounting hole 61H2. For example, the bracket 100 may be spanned over the fastening member 190 inserted into the first mounting hole 61H1 located on the left side of a pair of first mounting holes 61H1 and the second mounting hole 61H2 located on the left side of a pair of second mounting holes 61H2.

In this case, the long side direction of the bracket 100 may be a vertical direction. For example, the bracket 100 may be spanned over the fastening member 190 inserted into the first mounting hole 61H1 located on the right side among the pair of first mounting holes 61H1 and the second mounting hole 61H2 located on the right side among the pair of second mounting holes 61H2. In this case, the long side direction of the bracket 100 may be a vertical direction.

The head 191 and the neck 192 of the fastening member 190 may be inserted into the slot 134, 144 of the coupling portion 130, 140. The head 191 may be restricted from moving in the forward/rearward direction by the support portion 135, 145 of the coupling portion 130, 140. A portion of the neck 192 may be inserted into the slot 134, 144 of the coupling portion 130, 140, and the rest of the neck 192 may be in contact with the support portion 135, 145 of the coupling portion 130, 140. The neck 192 may be spanned over the support portion 135, 145 of the slot 134, 144 of the coupling portion 130, 140.

Referring to FIG. 16, when the bracket 100 is connected to the back cover 60, the protrusion 182 of the fixing portion 180 may be inserted into the hole 62H formed on the upper surface 62 of the back cover 60.

Referring to FIG. 2, a stand 70 may support the display panel 10. The stand 70 may support the display device 1, 1'. The stand 70 may be a component of the display device 1, 1', and the display device 1, 1' excluding the stand 70 may be referred to as a head 1, 1'.

The stand 70 may be coupled to the rear surface 61 of the back cover 60. The stand 70 may be coupled to the rear surface of the back cover 60 through a fastening member such as a screw. The stand 70 may separate the display panel 10 from the ground. The stand 70 may include a plurality of stands 70 that are spaced apart from each other along the lower side of the back cover 60. For example, the stand 70 may include a first stand and a second stand. The first stand may be adjacent to the lower side and the left side of the back cover 60, and the second stand may be adjacent to the lower side and the right side of the back cover 60. Accordingly, the stand 70 may stably support the head 1, 1'.

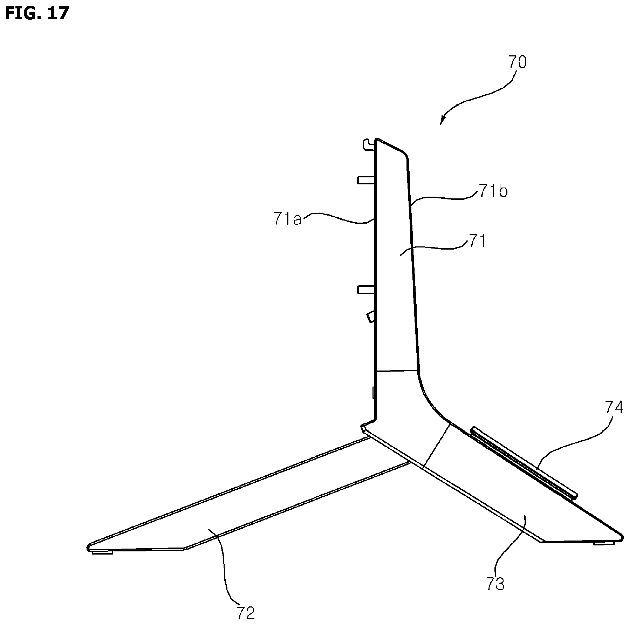

Referring to FIGS. 17 to 19, the stand 70 may include a body 71. The body 71 may be coupled to the rear surface 61 of the back cover 60. The body 70 may extend in a vertical direction. The body 71 may have an overall square pillar shape. A front surface 71a of the body 70 may face the rear surface 61 of the back cover 60. The front surface 71a of the body 70 may be coupled to the rear surface 61 of the back cover 60. A rear surface 71b of the body 70 may be located on the opposite side of the front surface 71a of the body 70.

The stand 70 may include a leg 72, 73. The leg 72, 73 may include a first leg 72 and a second leg 73. The first leg 72 may extend from the body 71. The first leg 72 may be connected to the lower side of the front surface 71a of the body 71. The first leg 72 may extend obliquely with respect to the body 71. At least a portion of the first leg 72 may be located in front of the display panel 10. The first leg 72 may form an obtuse angle with respect to the front surface 71a of the body 71. The second leg 73 may extend from the body 71. The second leg 73 may be connected to the lower side of the rear surface 71b of the body 71. The second leg 73 may be extended obliquely with respect to the body 71. The second leg 73 may form an obtuse angle with respect to the rear surface 71b of the body 71. The second leg 73 may be extended in a direction different from the extension direction of the first leg 72 with respect to the body 71. The second leg 73 may be extended to the rear of the back cover 60. The first leg 72 and the second leg 73 may form a certain angle. For example, the first leg 72 and the second leg 73 may form an obtuse angle.

The leg 72, 73 may have a square pillar shape. However, it is not limited thereto, and the leg 72, 73 may have a circular or polygonal plate shape, or may have a ring or open-ring shape.

The bracket 100 may be located within a horizontal distance H between the rear surface of the module cover 50 and the distal end of the second leg 73. Accordingly, the distance between a wall and the display device 1, 1' may be minimized.

The stand 70 may include a groove G. The groove G may include a first groove G1 formed in the body 71. The first groove G1 may be recessed in a direction from the rear surface 71b of the body 71 toward the front surface 71a. The first groove G1 may connect the front surface 71a and the rear surface 71b of the body 71 and may be open to the upper surface facing upward. The first groove G1 may be connected to a second groove G2 formed in the second leg 73.

The groove G may include the second groove G2 formed in the second leg 73. The second leg 73 may include a rear surface 72b connected to the rear surface 71b of the body 71, a front surface 72a located on the opposite side of the rear surface 72b, and a lower surface that connects the front surface 72a and the rear surface 72b and faces downward. The second groove G2 may be formed in the rear surface 72b of the second leg 73. The second groove G2 may be recessed in a direction from the rear surface 72b of the second leg 73 toward the front surface 72a of the second leg 73. The second groove G2 may be connected to the first groove G1. The second groove G2 may be opened to the lower surface of the second leg 73.

A connecting member such as a wire and a cable connected to peripheral devices stored in the bracket 100 may be located in the groove G.

The stand 70 may include a cover member 74. The cover member 74 may have a square plate shape. The cover member 74 may be coupled to the second leg 73. The cover member 74 may be coupled to the rear surface 72b of the second leg 73. The cover member 74 may be detachably coupled to the second leg 73. The cover member 74 may be slidably coupled to the second leg 73. The cover member 74 may cover at least a portion of the second groove G2.

Alternatively, the cover member 74 may be detachably coupled to the body 71 and may cover at least a portion of the first groove G1. Alternatively, the cover member 74 may be coupled to the body 71 and the second leg 73. For example, the cover member 74 may include a first cover member detachably coupled to the rear surface 71b of the body 71 and a second cover member detachably coupled to the rear surface 73b of the second leg 73. The first cover member and the second cover member may be spaced apart.

The cover member 74 may prevent connection members such as wire, and cable accommodated in the groove G from being separated from the groove G. Accordingly, the arrangement of connection member of peripheral devices of the display device 1, 1' accommodated in the rear of the display device 1, 1' may be facilitated.

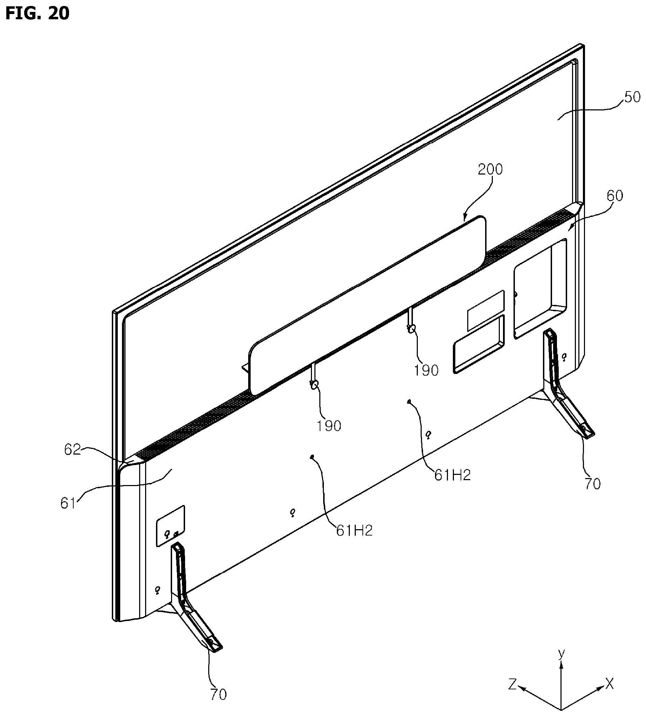

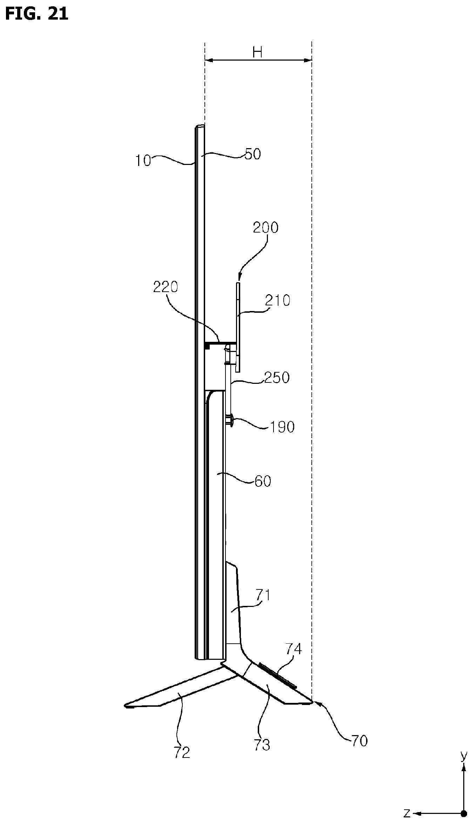

Referring to FIGS. 20 and 21, the display device 1, 1' may include a bracket 200. The bracket 200 may accommodate peripheral devices of the display device 1, 1'. The bracket 200 may be coupled to the rear of the back cover 60. The bracket 200 may be arranged at the rear of the module cover 50. The bracket 200 may be spaced rearward from the rear surface of the module cover 50. The bracket 200 may be located at a higher position than the upper surface 61 of the back cover 60. The plate 210 of the bracket 200 may overlap with the module cover 50 in the forward/rearward direction, and may not overlap with the back cover 60 in the forward/rearward direction.

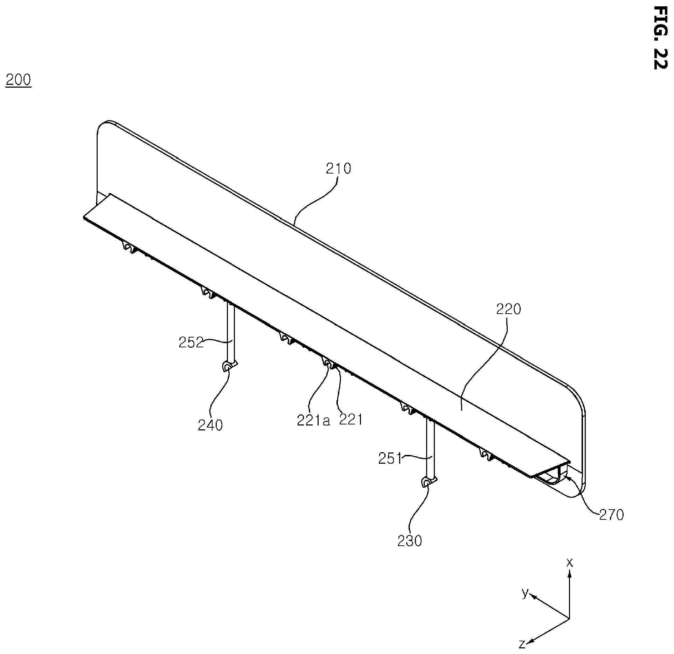

Referring to FIGS. 22 to 24, the plate 210 may be provided as a flat plate including a plane parallel to the rear surface of the module cover 50. The plate 210 may be formed in a square shape. For example, the plate 210 may be formed in a rectangular shape having a long side in the left-right direction and a short side in the up-down direction. The plate 210 may face the module cover 50 and may not face the back cover 60. The plate 210 may be spaced rearward from the module cover 50.

A shelf 220 may be located between the plate 210 and the module cover 50. The shelf 220 may extend from the plate 210 in an intersecting direction with respect to the plate 210 and the module cover 50. The shelf 220 may be formed as a flat plate having a plane perpendicular to a plane formed by the plate 210. One end of the shelf 220 may be coupled to the plate 210, and the other end of the shelf 220 may be adjacent to the rear surface of the module cover 50. The other end of the shelf 220 may be in contact with the module cover 50. In this case, the length of the shelf 220 in the forward/rearward direction may correspond to the distance between the rear surface of the module cover 50 and the plate 210. The other end of the shelf 220 may be spaced apart from the module cover 50 by a certain distance. Peripherals of the display device 1, 1' may be stored in the shelf 220.

A protrusion 221 may protrude downward from the shelf 220. The protrusion 221 may be located at the other end of the shelf 220. A groove 221a may be formed in the protrusion 221. The protrusion 221 may include a plurality of protrusions 221. The plurality of protrusions 221 may be spaced apart from each other in the left-right direction. A groove 221a may be formed in the protrusion 221. The groove 221a may be opened downward. The protrusion 221 may hold a connecting member such as a wire and cable of a peripheral device stored in the shelf 220.

A coupling portion 230, 240 may fix the bracket 200 to the display device 1, 1'. The coupling portion 230, 240 may fix the bracket 100 to the back cover 60. The coupling portion 230, 240 may include a first coupling portion 230 connected to a first fastening member 190a, and a second coupling portion 240 connected to a second fastening member 190b. A connecting portion 250 may include a first connecting bar 251 connected to the first coupling portion 230, a second connecting bar 252 connected to the second coupling portion 240, and a third connecting bar 253 connecting the first connecting bar 251 and the second connecting bar 252. One end of the first connecting bar 251 may be coupled to the first coupling portion 230, and the other end of the first connecting bar 251 may be coupled to one end of the third connecting bar 253. One end of the second connecting bar 252 may be coupled to the second coupling portion 240, and the other end of the second connecting bar 252 may be coupled to the other end of the third connecting bar 253. The first connecting bar 251 may extend in the up-down direction. The second connecting bar 252 may extend in the up-down direction. The first connecting bar 251 and the second connecting bar 252 may be parallel to each other. The third connecting bar 252 may extend in a direction perpendicular to the first connecting bar 251. The length of the third connecting bar 253 in the left-right direction may correspond to the distance between a pair of first mounting holes 61H1. The third connecting bar 253 may be fixed to the plate 210 by a rib 260 described below.

The first connecting bar 251 may extend below the plate 210. A portion of the first connecting bar 251 may face the module cover 50, and the remainder of the first connecting bar 251 may face the back cover 60. At least a portion of the first connecting bar 251 may be exposed to the rear of the display device 1, 1'. A portion of the first connecting bar 251 may overlap with the plate 210 in the forward/rearward direction, and the remainder of the first connecting bar 251 may not overlap with the plate 210 in the forward/rearward direction. The first connecting bar 251 may locate the first coupling portion 230 on the first fastening member 190a.

The second connecting bar 252 may extend below the plate 210. A portion of the second connecting bar 252 may face the module cover 50, and the remainder of the second connecting bar 252 may face the back cover 60. At least a portion of the second connecting bar 252 may be exposed to the rear of the display device 1, 1'. A portion of the second connecting bar 252 may overlap with the plate 210 in the forward/rearward direction, and the remainder of the second connecting bar 252 may not overlap with the plate 210 in the forward/rearward direction. The second connecting bar 252 may locate the second coupling portion 240 on the second fastening member 190b.

The connecting portion 230, 240 may be located on the neck 192 of the fastening member 190. The connecting portion 230, 240 may surround at least a portion of the neck 192 of the fastening member 190. The coupling portion 230, 240 may have a round shape. At least a portion of the coupling portion 230, 240 may have a curvature. The coupling portion 230, 240 may have a convex shape in the radial direction of the neck 192 of the fastening member 190. The inner surface of the coupling portion 230, 240 may be in contact with the outer surface of the neck 192 of the fastening member 190, and the curvature of the inner surface of the coupling portion 230, 240 may correspond to the curvature of the outer surface of the neck 192 of the fastening member 190. The first coupling portion 230 and the second coupling portion 240 may be formed in the same shape. The first coupling portion 230 and the second coupling portion 240 may be opened in the same direction. Alternatively, the first coupling portion 230 and the second coupling portion 240 may extend in the up-down direction and be symmetrical with respect to a center line passing through the center of the plate 210.

The rib 260 may be located on the plate 210. The rib 260 may be located below the shelf 220. The rib 260 may support the bottom surface of the shelf 220. The rib 260 may include a first surface that contacts the bottom surface of the shelf 220, a second surface that is located on the opposite side of the first surface, and a third surface that connects the first surface and the second surface and is located on the opposite side of the front surface of the plate 210. The first surface of the rib 260 may have a smaller area than the second surface of the rib 260. A groove 260a may be formed on the third surface of the rib 260. The groove 260a may be formed in a round shape. The groove 260a may fix the connecting portion 250. A third connecting bar 253 may be located in the groove 260a. The third connecting bar 253 may be fixed between the groove 260a and the bottom surface of the shelf 220. The rib 260 may include a plurality of ribs 260 spaced apart in the left-right direction. The third connecting bar 253 may be supported by the plurality of ribs 260. The third connecting bar 253 may be supported by some of the ribs 260 among the plurality of ribs 260.

A connecting frame 270 may include a first part 271 that is coupled to the left distal end of the shelf 220 and extends in the up-down direction, a second part 272 that is coupled to the right distal end of the shelf 220 and extends in the up-down direction, and a third part 273 that connects the first part 271 and the second part 272 and extends in the left-right direction. The connecting frame 270 may support the shelf 220. The connecting frame 270 may reinforce the rigidity of the shelf 220. A holder 274 may be located in the third part 273 of the connecting frame 270. The holder 274 may fix the first connecting bar 251. The holder 274 may fix the second connecting bar 252. The holder 274 may include a first portion supporting one side of the connecting bar 251, 252 and a first portion supporting the other side of the connecting bar 251, 252. The first portion and the second portion of the holder 274 may be spaced apart. The space between the first portion and the second portion of the holder 274 may be referred to as a groove 274a. The connecting bar 251, 252 may be attached and detached to the holder 274 through the groove 274a. The holder 274 may include a plurality of holders 274. The plurality of holders 274 may be spaced apart along the longitudinal direction of the third part 273.

The display device 1, 1' may include a repeater (not shown). The repeater may be installed on the lower side of the display device 1, 1'. The repeater may be installed on the second long side LS2. The repeater may be located on the lower side of the back cover 60. The repeater may be located on the lower side of the module cover. For example, the repeater may be attached to the display device 1, 1' through a double-sided tape. The repeater may be electrically connected to a peripheral device such as a set-top box accommodated in the bracket 100, 200. Accordingly, the repeater RT may transmit a signal (e.g., an IR signal) in front of the display device to the peripheral device.

Digital printing may be applied to the rear surface of the bracket 100, 200. A digital printed press may be attached to the rear surface of the bracket 100, 200. Digital printing may be applied to the rear surface of the module cover 50. A digital printed press may be attached to the rear surface of the module cover 50. The digital printing applied to the rear surface of the bracket 100, 200 and the digital printing applied to the rear surface of the module cover 50 may be the same. Through this, a unified outer shape design may be set. Alternatively, the digital printing applied to the rear surface of the bracket 100, 200 and the digital printing applied to the rear surface of the module cover 50 may be different. Through this, various outer shape designs may be set.

According to an aspect of the present disclosure, the display device includes: a display panel; a back cover located at a rear of the display panel; and a bracket which is located at a rear of the back cover, and detachably coupled to the back cover, in which the bracket includes: a plate which is arranged parallel to the back cover; and a shelf which extends in a forward direction from the plate, in which the back cover includes a mounting hole which is formed to penetrate the back cover, and to which a fastening member is coupled, and the bracket is spanned over the fastening member.

In addition, according to another aspect of the present disclosure, the bracket further includes a coupling portion which protrudes from an inner side of the plate toward the back cover, and faces a rear surface of the back cover, in which the coupling portion includes a slot into which a head of the fastening member is inserted, in which the slot is opened to a first surface in which the coupling portion faces the back cover, and a second surface which connects the first surface and the plate and faces downward.

In addition, according to another aspect of the present disclosure, the mounting hole includes: a pair of first mounting holes spaced apart from each other in a left-right direction, and a pair of second mounting holes spaced apart from each other in a left-right direction, the second mounting hole located below the first mounting hole, and the coupling portion includes a first coupling portion and a second coupling portion which are respectively coupled to the pair of first mounting holes.

In addition, according to another aspect of the present disclosure, the coupling portion includes a guide portion which protrudes along a boundary of the slot, in which the head of the fastening member overlaps with the guide portion in a forward/rearward direction.

In addition, according to another aspect of the present disclosure, the coupling portion includes a third surface which connects the first surface and the plate and faces the second surface, in which a distance between the guide portions increases in a direction from the third surface toward the second surface.

In addition, according to another aspect of the present disclosure, the shelf includes: a plurality of horizontal portions spaced apart from each other, a plurality of vertical portions which connect the plurality of horizontal portions and are spaced apart from each other, and a plurality of holes formed between the horizontal portion and the vertical portion.

In addition, according to another aspect of the present disclosure, the bracket further includes: a support frame which is located below the shelf on the plate, and extends in a direction intersecting with the plate and the back cover; and a rib which is located between the shelf and the support frame, and supports a bottom surface of the shelf.

In addition, according to another aspect of the present disclosure, the rib includes a first rib and a second rib which support a vertical portion located at both ends of the shelf among the plurality of vertical portions, and the bracket further includes a connection frame connecting the first rib, the coupling portion, and the first rib.

In addition, according to another aspect of the present disclosure, the display device further includes a module cover arranged between the display panel and the back cover, in which the back cover covers at least a portion of the module cover, and the shelf overlaps with an upper surface of the back cover in an up-down direction.

In addition, according to another aspect of the present disclosure, the back cover includes a plurality of holes formed on the upper surface of the back cover, the bracket includes a fixing portion which protrudes from the plate in a direction toward the module cover, in which the fixing portion includes: a fixing body; and a protrusion protruding downward from one end of the fixing body, in which the protrusion is inserted into at least one of the plurality of holes of the back cover.

In addition, according to another aspect of the present disclosure, the display device further includes a stand which is coupled to a rear surface of the back cover and supports the display panel, in which the stand includes: a body coupled to the rear surface of the back cover; a first leg which extends obliquely from the body, and is located in front of the display panel; and a second leg which extends obliquely from the body but extends in a different direction from an extension direction of the first leg, and is located at a rear of the back cover, in which the bracket is located within a horizontal distance between the rear surface of the back cover and a distal end of the second leg.

In addition, according to another aspect of the present disclosure, the body includes a first surface in contact with the back cover and a second surface located in an opposite side of the first surface in a thickness direction of the display panel, in which the stand includes: a groove which is formed by being recessed in a direction from the second surface of the body toward the first surface, and formed to extend to the second leg, and a cover member which is coupled to the second leg, and covers at least a portion of the groove.

In addition, according to another aspect of the present disclosure, the bracket has a smaller area than the display panel, and faces a central portion of the display panel with respect to the back cover.

In addition, according to another aspect of the present disclosure, digital printing is applied to a rear surface of the bracket and a rear surface of the back cover.

In addition, according to another aspect of the present disclosure, the display device further includes a repeater located on a lower side of the back cover.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

Although embodiments have been described with reference to a number of illustrative embodiments thereof, it should be understood that numerous other modifications and embodiments may be devised by those skilled in the art that will fall within the scope of the principles of this disclosure. More particularly, various variations and modifications are possible in the component parts and/or arrangements of the subject combination arrangement within the scope of the disclosure, the drawings and the appended claims.

## Claims

1. A display device comprising:
a display panel (10);
a back cover (60) located at a rear of the display panel (10); and
a bracket (100,200) which is located at a rear of the back cover (60), and detachably coupled to the back cover (60),
wherein the bracket (100,200) comprises:
a plate (110,210) which is arranged parallel to the back cover (60); and
a shelf (120,220) which extends in a forward direction from the plate (110,210),
wherein the back cover (60) comprises a plurality of mounting holes (61H1,61H2) which is formed to penetrate the back cover (60), and to which a plurality of fastening members (190) is coupled,
wherein the bracket (100,200) is spanned over the fastening members (190),
**characterized in that** the display device further comprises a module cover (50) arranged between the display panel (10) and the back cover (60),
wherein the back cover (60) covers at least a portion of the module cover (50), and
the shelf (120,220) overlaps with an upper surface (62) of the back cover (60) in an up-down direction,
wherein the back cover (60) comprises a plurality of holes (62H) formed on the upper surface (62) of the back cover (60),
wherein the bracket (100) comprises a fixing portion (180) which protrudes from the plate (110) in a direction toward the module cover (50),
wherein the fixing portion (180) comprises:
a fixing body (181); and
a protrusion (182) protruding downward from one end of the fixing body (181), and
wherein the protrusion (182) is inserted into at least one of the plurality of holes (62H) of the back cover (60).

2. The display device of claim 1, wherein the bracket (100) further comprises a coupling portion (130,140) which protrudes from an inner side of the plate (110) toward the back cover (60), and faces a rear surface of the back cover (60),
wherein the coupling portion (130,140) comprises a slot (134,144) into which a head (191) of the fastening members (190) is inserted,
wherein the slot (134,144) is opened to a first surface (131,141) in which the coupling portion (130,140) faces the back cover (60), and a second surface (132,142) which connects the first surface (131,141) and the plate (110) and faces downward.

3. The display device of claim 2, wherein the mounting holes (61H1,61H2) comprise:
a pair of first mounting holes (61H1) spaced apart from each other in a left-right direction, and
a pair of second mounting holes (61H2) spaced apart from each other in a left-right direction, the second mounting holes (61H2) located below the first mounting holes (61H1),
wherein the coupling portion (130,140) comprises a first coupling portion (130) and a second coupling portion (140) which are respectively coupled to the pair of first mounting holes (61H1).

4. The display device of claim 2, wherein the coupling portion (130,140) comprises a support portion (135,145) which protrudes along a boundary of the slot (134,144),
wherein the head (191) of a respective one of the fastening members (190) overlaps with the support portion (135,145) in a forward/rearward direction.

5. The display device of claim 4, wherein the coupling portion (130,140) comprises a third surface (133,143) which connects the first surface (131,141) and the plate (110) and faces the second surface (132,142),
wherein a distance between the support portions (135,145) increases in a direction from the third surface (133,143) toward the second surface (132,142).

6. The display device of claim 2, wherein the shelf (120) comprises:
a plurality of horizontal portions (121) spaced apart from each other,
a plurality of vertical portions (122) which connect the plurality of horizontal portions (121) and are spaced apart from each other, and
a plurality of holes (123) formed between the horizontal portion (121) and the vertical portion (122).

7. The display device of claim 6, wherein the bracket (100) further comprises:
a support frame (150) which is located below the shelf (120) on the plate (110), and extends in a direction intersecting with the plate (110) and the back cover (60); and
a plurality of ribs (160) which is located between the shelf (120) and the support frame (150), and supports a bottom surface of the shelf (120).

8. The display device of claim 7, wherein the plurality of ribs (160) comprises a first rib (161) and a second rib (162) which support a vertical portion (122a,122b) located at both ends of the shelf (120) among the plurality of vertical portions (122),
wherein the bracket (100) further comprises a connecting frame (170) connecting the first rib (161), the coupling portion (130,140), and the second rib (162).

9. The display device of claim 1, further comprising a stand (70) which is coupled to a rear surface of the back cover (60) and supports the display panel (10),
wherein the stand (70) comprises:
a body (71) coupled to the rear surface (61) of the back cover (60);
a first leg (72) which extends obliquely from the body (71), and is located in front of the display panel (10); and
a second leg (73) which extends obliquely from the body (71) but extends in a different direction from an extension direction of the first leg (72), and is located at a rear of the back cover (60),
wherein the bracket (100,200) is located within a horizontal distance (H) between the rear surface of the back cover (60) and a distal end of the second leg (73).

10. The display device of claim 9, wherein the body (71) comprises a first surface (71a) in contact with the back cover (60) and a second surface (71b) located in an opposite side of the first surface (71a) in a thickness direction of the display panel (10),
wherein the stand (70) comprises:
a groove (G) which is formed by being recessed in a direction from the second surface (71b) of the body (71) toward the first surface (71a), and formed to extend to the second leg (73), and
a cover member (74) which is coupled to the second leg (73), and covers at least a portion of the groove (G).

11. The display device of claim 1, wherein the bracket (100,200) has a smaller area than the display panel (10), and
faces a central portion of the display panel (10) with respect to the back cover (60).

12. The display device of claim 1, wherein digital printing is applied to a rear surface of the bracket (100,200) and a rear surface of the back cover (60).

13. The display device of claim 1, further comprising a repeater located on a lower side of the back cover (60).

## Patentansprüche

1. Anzeigevorrichtung, umfassend:
ein Anzeigepanel (10);
eine Rückabdeckung (60), die an der Rückseite des Anzeigepanels (10) angeordnet ist; und
eine Halterung (100, 200), die an der Rückseite der Rückabdeckung (60) angeordnet und lösbar mit der Rückabdeckung (60) verbunden ist,
wobei die Halterung (100, 200) umfasst:
eine Platte (110, 210), die parallel zur Rückabdeckung (60) angeordnet ist;
und
eine Ablage (120, 220), die sich von der Platte (110, 210) in Vorwärtsrichtung erstreckt,
wobei die Rückabdeckung (60) eine Mehrzahl von Befestigungslöchern (61H1, 61H2) umfasst, die so ausgebildet sind, dass sie die Rückabdeckung (60) durchdringen, und an denen eine Mehrzahl von Befestigungselementen (190) befestigt ist,
wobei die Halterung (100, 200) über die Befestigungselemente (190) gespannt ist,
**dadurch gekennzeichnet, dass** die Anzeigevorrichtung ferner eine Modulabdeckung (50) umfasst, die zwischen dem Anzeigepanel (10) und der Rückabdeckung (60) angeordnet ist,
wobei die Rückabdeckung (60) zumindest einen Teil der Modulabdeckung (50) abdeckt, und
wobei die Ablage (120, 220) in einer Auf-Ab-Richtung mit einer Oberseite (62) der Rückabdeckung (60) überlappt,
wobei die Rückabdeckung (60) eine Mehrzahl von Löchern (62H) umfasst, die an der Oberseite (62) der Rückabdeckung (60) ausgebildet sind,
wobei die Halterung (100) einen Befestigungsabschnitt (180) umfasst, der von der Platte (110) in Richtung der Modulabdeckung (50) vorsteht,
wobei der Befestigungsabschnitt (180) umfasst:
einen Befestigungskörper (181); und
einen Vorsprung (182), der von einem Ende des Befestigungskörpers (181) nach unten vorsteht, und
wobei der Vorsprung (182) in mindestens eines der Mehrzahl von Löchern (62H) der Rückabdeckung (60) eingeführt ist.

2. Anzeigevorrichtung nach Anspruch 1, wobei die Halterung (100) ferner einen Kupplungsabschnitt (130, 140) umfasst, der von einer Innenseite der Platte (110) in Richtung der Rückabdeckung (60) vorsteht und einer Rückseite der Rückabdeckung (60) zugewandt ist,
wobei der Kupplungsabschnitt (130, 140) einen Schlitz (134, 144) aufweist, in den ein Kopf (191) der Befestigungselemente (190) eingeführt wird,
wobei der Schlitz (134, 144) zu einer ersten Fläche (131, 141), an der der Kupplungsabschnitt (130, 140) der Rückabdeckung (60) zugewandt ist, und einer zweiten Fläche (132, 142) offen ist, die die erste Fläche (131, 141) mit der Platte (110) verbindet und nach unten gerichtet ist.

3. Anzeigevorrichtung nach Anspruch 2, wobei die Befestigungslöcher (61H1, 61H2) umfassen:
ein Paar erster Befestigungslöcher (61H1), die in einer Links-Rechts-Richtung voneinander beabstandet sind, und
ein Paar zweiter Befestigungslöcher (61H2), die in einer Links-Rechts-Richtung voneinander beabstandet sind, wobei sich die zweiten Befestigungslöcher (61H2) unterhalb der ersten Befestigungslöcher (61H1) befinden,
wobei der Kupplungsabschnitt (130, 140) einen ersten Kupplungsabschnitt (130) und einen zweiten Kupplungsabschnitt (140) umfasst, die jeweils mit dem Paar erster Befestigungslöcher (61H1) gekoppelt sind.

4. Anzeigevorrichtung nach Anspruch 2, wobei der Kupplungsabschnitt (130, 140) einen Stützabschnitt (135, 145) umfasst, der entlang einer Begrenzung des Schlitzes (134, 144) vorsteht,
wobei der Kopf (191) eines jeweiligen Befestigungselements (190) den Stützabschnitt (135, 145) in Vorwärts-/Rückwärtsrichtung überlappt.

5. Anzeigevorrichtung nach Anspruch 4, wobei der Kupplungsabschnitt (130, 140) eine dritte Fläche (133, 143) umfasst, die die erste Fläche (131, 141) und die Platte (110) verbindet und der zweiten Fläche (132, 142) zugewandt ist,
wobei sich ein Abstand zwischen den Stützabschnitten (135, 145) in einer Richtung von der dritten Fläche (133, 143) zur zweiten Fläche (132, 142) vergrößert.

6. Anzeigevorrichtung nach Anspruch 2, wobei die Ablage (120) umfasst:
eine Mehrzahl von horizontalen Abschnitten (121), die voneinander beabstandet sind,
eine Mehrzahl von vertikalen Abschnitten (122), die die Mehrzahl von horizontalen Abschnitten (121) verbindet und voneinander beabstandet sind, und
eine Mehrzahl von Löchern (123), die zwischen dem horizontalen Abschnitt (121) und dem vertikalen Abschnitt (122) ausgebildet sind.

7. Anzeigevorrichtung nach Anspruch 6, wobei die Halterung (100) ferner umfasst:
einen Stützrahmen (150), der sich unterhalb der Ablage (120) auf der Platte (110) befindet und sich in einer Richtung erstreckt, die die Platte (110) und die Rückabdeckung (60) schneidet; und
eine Mehrzahl von Rippen (160), die sich zwischen der Ablage (120) und dem Stützrahmen (150) befinden und eine Unterseite der Ablage (120) stützen.

8. Anzeigevorrichtung nach Anspruch 7, wobei die Mehrzahl von Rippen (160) eine erste Rippe (161) und eine zweite Rippe (162) umfasst, die einen vertikalen Abschnitt (122a, 122b) stützen, der sich an beiden Enden der Ablage (120) unter der Mehrzahl von vertikalen Abschnitten (122) befindet,
wobei die Halterung (100) ferner einen Verbindungsrahmen (170) umfasst, der die erste Rippe (161), den Kupplungsabschnitt (130, 140) und die zweite Rippe (162) miteinander verbindet.

9. Anzeigevorrichtung nach Anspruch 1, die ferner einen Ständer (70) umfasst, der mit einer Rückseite der Rückabdeckung (60) verbunden ist und das Anzeigepanel (10) trägt,
wobei der Ständer (70) umfasst:
einen Körper (71), der mit der Rückseite (61) der Rückabdeckung (60) verbunden ist;
ein erstes Bein (72), das sich schräg vom Körper (71) erstreckt und vor dem Anzeigefeld (10) angeordnet ist; und
ein zweites Bein (73), das sich schräg vom Körper (71) erstreckt, sich jedoch in einer anderen Richtung als die Ausdehnungsrichtung des ersten Beins (72) erstreckt und an einer Rückseite der Rückabdeckung (60) angeordnet ist,
wobei sich die Halterung (100, 200) innerhalb eines horizontalen Abstands (H) zwischen der Rückseite der Rückabdeckung (60) und einem distalen Ende des zweiten Beins (73) befindet.

10. Anzeigevorrichtung nach Anspruch 9, wobei der Körper (71) eine erste Oberfläche (71a), die mit der Rückabdeckung (60) in Kontakt steht, und eine zweite Oberfläche (71b), die in einer Dickenrichtung des Anzeigepanels (10) auf der der ersten Oberfläche (71a) gegenüberliegenden Seite angeordnet ist, aufweist,
wobei der Ständer (70) umfasst:
eine Nut (G), die durch eine Vertiefung in einer Richtung von der zweiten Oberfläche (71b) des Körpers (71) zur ersten Oberfläche (71a) hin ausgebildet ist und so geformt ist, dass sie sich bis zum zweiten Bein (73) erstreckt, und
ein Abdeckelement (74), das mit dem zweiten Bein (73) verbunden ist und zumindest einen Teil der Nut (G) abdeckt.

11. Anzeigevorrichtung nach Anspruch 1, wobei die Halterung (100, 200) eine kleinere Fläche als das Anzeigepanel (10) aufweist, und
in Bezug auf die Rückabdeckung (60) einem mittleren Abschnitt das Anzeigepanels (10) zugewandt ist.

12. Anzeigevorrichtung nach Anspruch 1, wobei ein Digitaldruck auf eine Rückseite der Halterung (100, 200) und eine Rückseite der Rückabdeckung (60) aufgebracht ist.

13. Anzeigevorrichtung nach Anspruch 1, die ferner einen Repeater umfasst, der an einer Unterseite der Rückabdeckung (60) angeordnet ist.

## Revendications

1. Dispositif d'affichage, comprenant:
un écran d'affichage (10);
un couvercle arrière (60) situé à l'arrière de l'écran d'affichage (10); et
un support (100.200) qui est situé à l'arrière du couvercle arrière (60), et accouplé amovible au couvercle arrière (60),
dans lequel le support (100.200) comprend:
une plaque (110, 210) qui est parallèle au couvercle arrière (60); et
une tablette (120, 220) qui s'étend vers l'avant à partir de la plaque (110, 210),
dans lequel le couvercle arrière (60) comporte une pluralité de trous de fixation (61H1, 61H2) formés de manière à traverser le couvercle arrière (60), et auxquels sont associés une pluralité d'éléments de fixation (190),
dans lequel le support (100, 200) enjambe les éléments de fixation (190),
**caractérisé en ce que** le dispositif d'affichage comprend en outre un couvercle de module (50) disposé entre l'écran d'affichage (10) et le couvercle arrière (60),
dans lequel le couvercle arrière (60) recouvre au moins une partie du couvercle du module (50), et
la tablette (120, 220) chevauche la surface supérieure (62) du couvercle arrière (60) du haut vers le bas,
dans lequel le couvercle arrière (60) comporte une pluralité de trous (62H) formés sur la surface supérieure (62) du couvercle arrière (60),
dans lequel le support (100) comprend une portion de fixation (180) qui fait saillie de la plaque (110) en direction du couvercle du module (50),
dans lequel la partie de fixation (180) comprend:
un corps de fixation (181); et
une saillie (182) faisant saillie vers le bas à partir d'une extrémité du corps de fixation (181), et
dans lequel la saillie (182) est insérée dans au moins l'un parmi la pluralité de trous (62H) du couvercle arrière (60).

2. Dispositif d'affichage selon la revendication 1, dans lequel le support (100) comprend en outre une portion d'accouplement (130, 140) qui fait saillie de la face interne de la plaque (110) en direction du couvercle arrière (60) et qui est tournée vers la surface arrière du couvercle arrière (60),
dans lequel la partie d'accouplement (130, 140) comprend une fente (134, 144) dans laquelle est insérée une tête (191) des éléments de fixation (190),
dans lequel la fente (134, 144) débouche sur une première surface (131, 141) dans laquelle la portion d'accouplement (130, 140) fait face au couvercle arrière (60), et sur une deuxième surface (132, 142) qui relie la première surface (131, 141) à la plaque (110) et est orientée vers le bas.

3. Dispositif d'affichage selon la revendication 2, dans lequel les trous de montage (61H1,61H2) comprennent:
une paire de premiers trous de montage (61H1) espacés l'un de l'autre dans le sens gauche-droite, et
une paire de deuxièmes trous de fixation (61H2) espacés l'un de l'autre dans le sens gauche-droite, les deuxièmes trous de fixation (61H2) étant situés en dessous des premiers trous de fixation (61H1),
dans lequel la partie d'accouplement (130, 140) comprend une première portion d'accouplement (130) et une deuxième portion d'accouplement (140) qui sont respectivement accouplées à la paire de premiers trous de montage (61H1).

4. Dispositif d'affichage selon la revendication 2, dans lequel la portion d'accouplement (130, 140) comprend une portion de support (135, 145) qui fait saillie le long d'un bord de la fente (134, 144),
dans lequel la tête (191) de l'un respectif parmi les éléments de fixation (190) chevauche la portion de support (135, 145) dans le sens avant-arrière.

5. Dispositif d'affichage selon la revendication 4, dans lequel la portion d'accouplement (130, 140) comprend une troisième surface (133, 143) qui relie la première surface (131, 141) et la plaque (110) et qui est tournée vers la deuxième surface (132, 142),
dans lequel la distance entre les portions de support (135, 145) augmente dans une direction allant de la troisième surface (133, 143) à la deuxième surface (132, 142).

6. Dispositif d'affichage selon la revendication 2, dans lequel la tablette (120) comprend:
une pluralité de portions horizontales (121) espacées les unes des autres,
une pluralité de portions verticales (122) qui relient la pluralité de portions horizontales (121) et sont espacées les unes des autres, et
une pluralité de trous (123) formés entre la portion horizontale (121) et la portion verticale (122).

7. Dispositif d'affichage selon la revendication 6, dans lequel le support (100) comprend en outre:
un cadre de support (150) situé sous la tablette (120) sur la plaque (110) et s'étendant dans une direction perpendiculaire à la plaque (110) et au couvercle arrière (60); et
une pluralité de nervures (160) situées entre la tablette (120) et le cadre de support (150), et qui soutiennent la surface inférieure de la tablette (120).

8. Dispositif d'affichage selon la revendication 7, dans lequel la pluralité de nervures (160) comprend une première nervure (161) et une deuxième nervure (162) qui soutiennent une portion verticale (122a, 122b) située aux deux extrémités de la tablette (120) parmi la pluralité de portions verticales (122),
dans lequel le support (100) comprend en outre un cadre de liaison (170) reliant la première nervure (161), la portion d'accouplement (130, 140) et la deuxième nervure (162).

9. Dispositif d'affichage selon la revendication 1, comprenant en outre un pied (70) qui est accouplé à la surface arrière du couvercle arrière (60) et qui soutient l'écran d'affichage (10),
dans lequel le pied (70) comprend:
un corps (71) couplé à la surface arrière (61) du couvercle arrière (60);
une première patte (72) qui s'étend obliquement à partir du corps (71) et qui est située devant l'écran d'affichage (10); et
une deuxième patte (73) qui s'étend obliquement à partir du corps (71), mais s'étend dans une direction différente de la direction d'extension de la première patte (72), et qui est située à l'arrière du couvercle arrière (60),
dans lequel le support (100, 200) est situé à une distance horizontale (H) entre la surface arrière du couvercle arrière (60) et l'extrémité distale de la deuxième patte (73).

10. Dispositif d'affichage selon la revendication 9, dans lequel le corps (71) comprend une première surface (71a) en contact avec le couvercle arrière (60) et une deuxième surface (71b) située du côté en regard à la première surface (71a) dans le sens de l'épaisseur de l'écran d'affichage (10),
dans lequel le pied (70) comprend:
une rainure (G) qui est formée en retrait dans une direction allant de la deuxième surface (71b) du corps (71) à la première surface (71a), et qui est conçue pour s'étendre jusqu'à la deuxième patte (73), et
un élément de couvercle (74) qui est relié à la deuxième patte (73) et recouvre au moins une partie de la rainure (G).

11. Dispositif d'affichage selon la revendication 1, dans lequel le support (100, 200) a une surface inférieure à celle de l'écran d'affichage (10), et
est orientée vers la portion centrale de l'écran d'affichage (10) par rapport au couvercle arrière (60).

12. Dispositif d'affichage selon la revendication 1, dans lequel une impression numérique est appliquée sur la surface arrière du support (100, 200) et sur la surface arrière du couvercle arrière (60).

13. Dispositif d'affichage selon la revendication 1, comprenant en outre un répétiteur situé sur une face inférieure du couvercle arrière (50).
